# EUROPEAN PATENT APPLICATION

(11) **EP 4 318 608 A1**
(43) Date of publication of application: **07.02.2024**
(21) Application number: 22775080.9
(22) Date of filing: 08.03.2022
(51) Int. Cl.: H01L 31/10, H01L 27/146

(54) **SOLID-STATE IMAGING ELEMENT AND METHOD FOR PRODUCING SAME**

(30) Priority: 22.03.2021 JP 2021047796
(71) Applicant: Sony Semiconductor Solutions Corporation, Atsugi-shi, Kanagawa 243-0014 (JP)
(72) Inventor: MATSUMOTO Ryosuke, Atsugi-shi, Kanagawa 243-0014 (JP); FUJIMOTO Yuta, Atsugi-shi, Kanagawa 243-0014 (JP); MINARI Hideki, Atsugi-shi, Kanagawa 243-0014 (JP)
(74) Representative: Müller Hoffmann & Partner
(86) International application number: PCT/JP2022/009941
(87) International publication number: WO 2022/202286

(57) **Abstract**

To suppress a decrease in quantum efficiency and to suppress an increase in parasitic capacitance and dark current.

A solid-state imaging element includes: a photoelectric conversion layer containing a compound semiconductor material; two semiconductor layers laminated and disposed on an opposite side of a light incident surface of the photoelectric conversion layer, the two semiconductor layers containing impurities of different conductivity types from each other; and a diffusion layer disposed in sidewalls of the photoelectric conversion layer and the two semiconductor layers, the diffusion layer containing impurities of an impurity concentration higher than that of the two semiconductor layers, in which the two semiconductor layers has a width in a plane direction excluding the diffusion layer in the sidewalls, the width being narrower than a width of the photoelectric conversion layer in a plane direction excluding the diffusion layer in the sidewall.

## Description

### TECHNICAL FIELD

The present disclosure relates to a solid-state imaging element and a manufacturing method thereof.

### BACKGROUND ART

In an image sensor for a short infrared camera, a compound semiconductor is used. Furthermore, a solid-state imaging element used for the image sensor is desired to suppress movement of signal charges between adjacent pixels and to reduce dark current. Therefore, a structure in which a groove for separating pixels is provided and an impurity diffusion layer is provided on a side surface of the groove has been proposed (see, for example, Patent Document 1).

### CITATION LIST

### PATENT DOCUMENT

Patent Document 1: International Publication No. WO 2018/212175

### SUMMARY OF THE INVENTION

### PROBLEMS TO BE SOLVED BY THE INVENTION

However, as the impurity diffusion layer becomes thicker, for example, a photoelectric conversion layer becomes narrower, and there is a possibility that quantum efficiency decreases. On the other hand, as the impurity diffusion layer becomes thinner, for example, a depletion layer caused by a pn junction in a semiconductor layer on the photoelectric conversion layer becomes wider, and there is a possibility that parasitic capacitance and dark current increase. That is, the thickness of the impurity diffusion layer is in a trade-off relationship, and it is difficult to achieve both of the high quantum efficiency and the low parasitic capacitance and dark current.

Therefore, the present disclosure provides a solid-state imaging element that can suppress a decrease in quantum efficiency and suppress an increase in parasitic capacitance and dark current, and a manufacturing method thereof.

### SOLUTIONS TO PROBLEMS

In order to solve the problem described above, according to the present disclosure, there is provided is a solid-state imaging element including:
a photoelectric conversion layer containing a compound semiconductor material;
two semiconductor layers laminated and disposed on an opposite side of a light incident surface of the photoelectric conversion layer, the two semiconductor layers containing impurities of conductivity types different from each other; and
a diffusion layer disposed in sidewalls of the photoelectric conversion layer and the two semiconductor layers, the diffusion layer containing impurities of an impurity concentration higher than an impurity concentration of the two semiconductor layers, in which
the two semiconductor layers have a width in a plane direction excluding the diffusion layer in the sidewalls, the width being narrower than a width of the photoelectric conversion layer in a plane direction excluding the diffusion layer in the sidewall.

The two semiconductor layers may include:
a first semiconductor layer containing impurities of a first conductivity type;
a second semiconductor layer disposed between the first semiconductor layer and the photoelectric conversion layer and containing impurities of a second conductivity type, and
the diffusion layer may be disposed in the sidewalls of the first semiconductor layer and the second semiconductor layer, and may contain impurities of the second conductivity type having an impurity concentration higher than an impurity concentration of the second semiconductor layer.

The diffusion layer in the sidewalls of the two semiconductor layers may be thicker than the diffusion layer in the sidewall of the photoelectric conversion layer.

The width in the plane direction of the two semiconductor layers including the diffusion layer in the sidewalls may be substantially the same as the width in the plane direction of the photoelectric conversion layer including the diffusion layer in the sidewall, or the width in the plane direction may be continuously narrowed from the side of the light incident surface of the photoelectric conversion layer including the diffusion layer in the sidewall toward the two semiconductor layers.

There may be further provided a third semiconductor layer disposed on the side of the light incident surface of the photoelectric conversion layer and having the same conductivity type as the photoelectric conversion layer, and
the diffusion layer disposed in a sidewall of the third semiconductor layer may be thicker than the diffusion layer in the sidewall of the photoelectric conversion layer and thinner than the diffusion layer in the sidewalls of the two semiconductor layers.

The two semiconductor layers may include:
a first semiconductor layer containing impurities of a first conductivity type;
a second semiconductor layer disposed between the first semiconductor layer and the photoelectric conversion layer and containing impurities of a second conductivity type,
there may be further provided a first insulating film disposed on the first semiconductor layer and disposed inside the first semiconductor layer in plan view from an opposite side of the light incident surface, and
the diffusion layer in the sidewall of the first semiconductor layer may be thicker than the diffusion layer in the sidewall of the second semiconductor layer.

The two semiconductor layers including the diffusion layer in the sidewalls may have a width in the plane direction gradually narrowed from the photoelectric conversion layer including the diffusion layer in the sidewall.

The diffusion layer in the sidewalls of the two semiconductor layers may have a substantially same thickness as a thickness of the diffusion layer in the sidewall of the photoelectric conversion layer.

The diffusion layer in the sidewalls of the two semiconductor layers may be thicker than the diffusion layer in the sidewall of the photoelectric conversion layer.

There may be further provided:
a first insulating film disposed so as to cover the diffusion layer in the sidewalls of the two semiconductor layers; and
a second insulating film disposed so as to cover the diffusion layer in the sidewall of the photoelectric conversion layer and being different from the first insulating film.

There may be further provided an electrode that is disposed so as to sandwich the two semiconductor layers between the electrode and the photoelectric conversion layer and reads out charges photoelectrically converted by the photoelectric conversion layer, and
the diffusion layer in the sidewalls of the two semiconductor layers may be disposed so as to be close to the electrode while being spaced apart from the electrode.

There may be further provided:
an electrode that is disposed so as to sandwich the two semiconductor layers between the electrode and the photoelectric conversion layer and reads out charges photoelectrically converted by the photoelectric conversion layer; and
a fourth semiconductor layer that is disposed between the two semiconductor layers and the electrode and has a conductivity type different from a conductivity type of the photoelectric conversion layer, and
the diffusion layer of the sidewalls of the two semiconductor layers may be disposed so as to be close to the fourth semiconductor layer while being spaced apart from the fourth semiconductor layer.

The two semiconductor layers may have band gap energy larger than band gap energy of the photoelectric conversion layer.

According to the present disclosure, there is provided a manufacturing method of a solid-state imaging element, the manufacturing method including:
forming a laminate of a photoelectric conversion layer containing a compound semiconductor material and two semiconductor layers that are laminated, the two semiconductor layers containing impurities of conductivity types different from each other;
forming a diffusion layer in the two semiconductor layers, the diffusion layer containing impurities of an impurity concentration higher than an impurity concentration of the two semiconductor layers;
forming a first groove that exposes the diffusion layer in sidewalls of the two semiconductor layers and a sidewall of the photoelectric conversion layer; and
forming the diffusion layer in the sidewall of the photoelectric conversion layer, and making the diffusion layer in the sidewalls of the two semiconductor layers thicker than the diffusion layer in the sidewall of the photoelectric conversion layer.

There may be further provided:
after forming the laminate,
forming a first insulating film on the laminate, the first insulating film being disposed for each pixel;
forming the diffusion layer in the two semiconductor layers using the first insulating film as a mask;
after forming the first groove,
removing an outer peripheral part of the first insulating film such that the first insulating film is disposed inside the two semiconductor layers in plan view from an opposite side of a light incident surface of the photoelectric conversion layer; and
forming the diffusion layer in the sidewall of the photoelectric conversion layer using the first insulating film as a mask, and making the diffusion layer in the sidewalls of the two semiconductor layers thicker than the diffusion layer in the sidewall of the photoelectric conversion layer.

According to the present disclosure, there is provided a manufacturing method of a solid-state imaging element, the manufacturing method including:
forming a laminate of a photoelectric conversion layer containing a compound semiconductor material and two semiconductor layers that are laminated, the two semiconductor layers containing impurities of conductivity types different from each other;
forming a first groove that exposes sidewalls of the two semiconductor layers and a sidewall of the photoelectric conversion layer;
removing a part of the two semiconductor layers from a side of the sidewalls;
forming a diffusion layer in the sidewalls of the photoelectric conversion layer and the two semiconductor layers, the diffusion layer containing impurities of an impurity concentration higher than an impurity concentration of the two semiconductor layers.

According to the present disclosure, there is provided a manufacturing method of a solid-state imaging element, the manufacturing method including:
forming a laminate of a photoelectric conversion layer containing a compound semiconductor material and two semiconductor layers that are laminated, the two semiconductor layers containing impurities of conductivity types different from each other;
forming a second groove that exposes sidewalls of the two semiconductor layers;
forming a diffusion layer in the sidewalls of the two semiconductor layers, the diffusion layer containing impurities of an impurity concentration higher than an impurity concentration of the two semiconductor layers;
forming a third groove that exposes a sidewall of the photoelectric conversion layer, the third groove being narrower than the second groove; and
forming the diffusion layer in the sidewall of the photoelectric conversion layer, and making the diffusion layer in the sidewalls of the two semiconductor layers thicker than the diffusion layer in the sidewall of the photoelectric conversion layer.

There may be further provided:
after forming the diffusion layer in the sidewalls of the two semiconductor layers,
forming a first insulating film covering the diffusion layer in the sidewalls of the two semiconductor layers; and
after forming the diffusion layer in the sidewall of the photoelectric conversion layer and thickening the diffusion layer in the sidewalls of the two semiconductor layers,
forming a second insulating film different from the first insulating film, the second insulating film covering the diffusion layer in the sidewall of the photoelectric conversion layer.

### BRIEF DESCRIPTION OF DRAWINGS

Fig. 1 is a schematic cross-sectional view illustrating a schematic configuration of a solid-state imaging element according to a first embodiment of the present disclosure.
Fig. 2 is a schematic diagram illustrating a planar configuration of the solid-state imaging element illustrated in Fig. 1.
Fig. 3A is a schematic cross-sectional view illustrating a step of the manufacturing method of the solid-state imaging element illustrated in Fig. 1.
Fig. 3B is a schematic cross-sectional view illustrating a step following Fig. 3A.
Fig. 3C is a schematic cross-sectional view illustrating a step following Fig. 3B.
Fig. 3D is a schematic cross-sectional view illustrating a step following Fig. 3C.
Fig. 3E is a schematic cross-sectional view illustrating a step following Fig. 3D.
Fig. 3F is a schematic cross-sectional view illustrating a step following Fig. 3E.
Fig. 3G is a schematic cross-sectional view illustrating a step following Fig. 3F.
Fig. 4 is a schematic cross-sectional view illustrating a schematic configuration of the solid-state imaging element according to a first modified example of the first embodiment.
Fig. 5A is a schematic cross-sectional view illustrating a step of the manufacturing method of the solid-state imaging element illustrated in Fig. 4.
Fig. 5B is a schematic cross-sectional view illustrating a step following Fig. 5A.
Fig. 5C is a schematic cross-sectional view illustrating a step following Fig. 5B.
Fig. 6 is a schematic cross-sectional view illustrating a schematic configuration of the solid-state imaging element according to a second modified example of the first embodiment.
Fig. 7 is a schematic cross-sectional view illustrating a schematic configuration of the solid-state imaging element according to a third modified example of the first embodiment.
Fig. 8 is a schematic cross-sectional view illustrating a schematic configuration of the solid-state imaging element according to a fourth modified example of the first embodiment.
Fig. 9 is a schematic cross-sectional view illustrating a schematic configuration of the solid-state imaging element according to a fifth modified example of the first embodiment.
Fig. 10 is a schematic cross-sectional view illustrating a schematic configuration of the solid-state imaging element according to a sixth modified example of the first embodiment.
Fig. 11 is a schematic cross-sectional view illustrating a schematic configuration of a solid-state imaging element according to a second embodiment of the present disclosure.
Fig. 12 is a schematic diagram illustrating a planar configuration of the solid-state imaging element illustrated in Fig. 11.
Fig. 13A is a schematic cross-sectional view illustrating a step of a manufacturing method of the solid-state imaging element illustrated in Fig. 11.
Fig. 13B is a schematic cross-sectional view illustrating a step following Fig. 13A.
Fig. 13C is a schematic cross-sectional view illustrating a step following Fig. 13B.
Fig. 13D is a schematic cross-sectional view illustrating a step following Fig. 13C.
Fig. 13E is a schematic cross-sectional view illustrating a step following Fig. 13D.
Fig. 14 is a schematic cross-sectional view illustrating a schematic configuration of the solid-state imaging element according to a first modified example of the second embodiment.
Fig. 15 is a schematic diagram illustrating a planar configuration of the solid-state imaging element illustrated in Fig. 14.
Fig. 16A is a schematic cross-sectional view illustrating a step of the manufacturing method of the solid-state imaging element illustrated in Fig. 14.
Fig. 16B is a schematic cross-sectional view illustrating a step following Fig. 16A.
Fig. 16C is a schematic cross-sectional view illustrating a step following Fig. 16B.
Fig. 16D is a schematic cross-sectional view illustrating a step following Fig. 16C.
Fig. 16E is a schematic cross-sectional view illustrating a step following Fig. 16D.
Fig. 17 is a schematic cross-sectional view illustrating a schematic configuration of the solid-state imaging element according to a second modified example of the second embodiment.
Fig. 18 is a schematic cross-sectional view illustrating a schematic configuration of the solid-state imaging element according to a third modified example of the second embodiment.
Fig. 19 is a block diagram illustrating an example of a schematic configuration of a vehicle control system.
Fig. 20 is an explanatory diagram illustrating an example of installation positions of an outside-vehicle information detecting unit and imaging sections.

### MODE FOR CARRYING OUT THE INVENTION

Hereinafter, embodiments of a solid-state imaging element and a manufacturing method thereof will be described with reference to the drawings. Although principal components of the solid-state imaging element and the manufacturing method thereof will be mainly described below, the solid-state imaging element and the manufacturing method thereof may include components and functions that are not illustrated or described. The following description does not exclude components and functions that are not illustrated or described.

### <First embodiment>

### [Configuration]

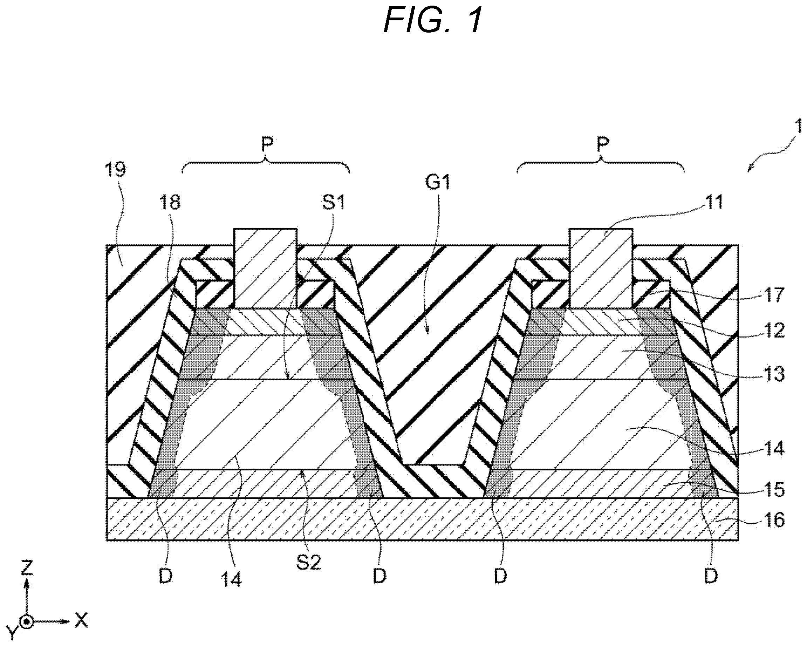

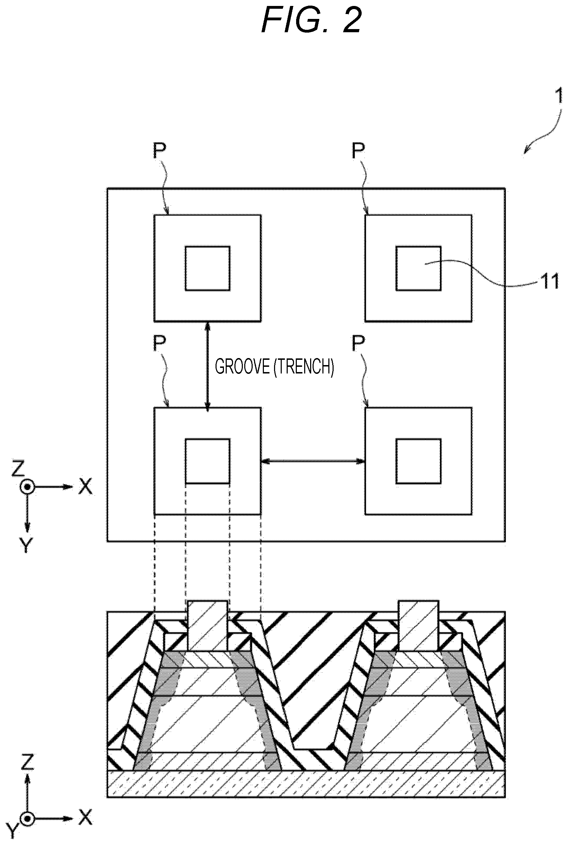

Figs. 1 and 2 illustrate a schematic configuration of a solid-state imaging element (solid-state imaging element 1) according to a first embodiment of the present disclosure. Fig. 1 illustrates a cross-sectional configuration of the solid-state imaging element 1, and Fig. 2 illustrates a planar configuration of the solid-state imaging element 1. The solid-state imaging element 1 is applied to, for example, an infrared sensor or the like using a compound semiconductor material such as a group III-V semiconductor, and has a photoelectric conversion function for light having a wavelength in, for example, a visible region (for example, 380 nm or more and less than 780 nm) to a short infrared region (for example, 780 nm or more and less than 2400 nm). The solid-state imaging element 1 is provided with, for example, a plurality of light receiving unit regions P (pixels P) two-dimensionally arranged in a matrix. Here, the solid-state imaging element 1 will be described as a specific example of the photoelectric conversion element of the present technology.

In the pixel P of the solid-state imaging element 1, a first electrode 11, a first semiconductor layer 12, a second semiconductor layer 13, a light absorbing layer 14 (photoelectric conversion layer), a contact layer 15, and a second electrode 16 are provided in this order. The light absorbing layer 14 has a first surface S1 (surface opposite to the light incident surface) and a second surface S2 (light incident surface) facing each other, and the second semiconductor layer 13 is provided on the first surface S1 and the contact layer 15 is provided on the second surface S2. In the solid-state imaging element 1, light incident from the second electrode 16 side is incident on the second surface S2 of the light absorbing layer 14 via the contact layer 15. An insulating film 17 is provided around the first electrode 11. The solid-state imaging element 1 has a diffusion region D (diffusion layer) between the adjacent pixels P. The diffusion region D is provided over the first semiconductor layer 12, the second semiconductor layer 13, the light absorbing layer 14, and the contact layer 15.

The first electrode 11 is a readout electrode to which a voltage for reading signal charges (holes or electrons; hereinafter, for convenience, the description is made that signal charges are assumed to be electrons) generated in the light absorbing layer 14 is supplied, and is provided for each pixel P while facing the first surface S1 of the light absorbing layer 14. The first electrode 11 is electrically connected to a pixel circuit for reading out the signal and a silicon semiconductor substrate via, for example, a bump, a via, and the like. For example, various wiring lines and the like are provided on the silicon semiconductor substrate. The first electrode 11 is provided, for example, in contact with the first semiconductor layer 12. The planar shape of the first electrode 11 is, for example, a quadrangular shape, and the plurality of first electrodes 11 is disposed to be separated from each other. The first electrode 11 is embedded in the opening of the insulating film 17, and the insulating film 17, a coating film 18, and a protective film 19 are provided between the adjacent first electrodes 11.

The first electrode 11 includes, for example, any simple substance of titanium (Ti), tungsten (W), titanium nitride (TiN), platinum (Pt), gold (Au), copper (Cu), germanium (Ge), palladium (Pd), zinc (Zn), nickel (Ni), indium (In), and aluminum (Al), or an alloy containing at least one of the above substances. The first electrode 11 may be a single film of such a constituent material, or may be a laminated film obtained by combining two or more kinds of the materials.

The first semiconductor layer 12 and the second semiconductor layer 13 are provided, for example, in common for all the pixels P. As described later, the first semiconductor layer 12 and the second semiconductor layer 13 are provided for forming a pn junction, and include a compound semiconductor material having a band gap energy larger than a band gap energy of the compound semiconductor material constituting the light absorbing layer 14. In a case where the light absorbing layer 14 includes, for example, indium gallium arsenide (InGaAs, having a band gap energy of 0.75 eV), indium phosphide (InP, having a band gap energy 1.35 eV) can be used for the first semiconductor layer 12 and the second semiconductor layer 13. For the first semiconductor layer 12 and the second semiconductor layer 13, for example, a group III-V semiconductor containing at least any one of indium (In), gallium (Ga), aluminum (Al), arsenic (As), phosphorus (P), antimony (Sb), and nitrogen (N) can be used. Specific examples thereof include indium gallium arsenide phosphide (InGaAsP), indium arsenide antimony (InAsSb), indium gallium phosphide (InGaP), gallium arsenide antimony (GaAsSb), indium aluminum arsenide (InAlAs), and the like in addition to InP. The sum of the thickness of the first semiconductor layer 12 and the thickness of the second semiconductor layer 13 is, for example, 100 nm to 3,000 nm.

As the total film thickness of the first semiconductor layer 12 and the second semiconductor layer 13 becomes less than 100 nm, there is a possibility that, for example, a pn junction formed between the first semiconductor layer 12 and the second semiconductor layer 13 comes into contact with, for example, the first electrode 11 and the light absorbing layer 14. Furthermore, as the total film thickness of the first semiconductor layer 12 and the second semiconductor layer 13 becomes less than 100 nm, there is a possibility that etching damage at the time of forming a first groove G1 to be described later or damage at the time of forming the coating film 18 to be described later reaches the light absorbing layer 14. These cause an increase in dark current. As the total film thickness of the first semiconductor layer 12 and the second semiconductor layer 13 becomes larger than 3,000 nm, it is difficult to form the diffusion region D extending to the light absorbing layer 14, and it is difficult to electrically separate the adjacent pixels P.

The first semiconductor layer 12 disposed between the first electrode 11 and the second semiconductor layer 13 has, for example, n-type (first conductivity type) carriers. The second semiconductor layer 13 is disposed between the first semiconductor layer 12 and the light absorbing layer 14 (first surface S1) and has, for example, p-type (second conductivity type) carriers whose conductivity type is reversed from that of the first semiconductor layer 12. With this arrangement, a pn junction is formed between the first semiconductor layer 12 and the second semiconductor layer 13 (in an interface between the first semiconductor layer 12 and the second semiconductor layer 13). Although details will be described later, by having the pn junction formed at the interface between the first semiconductor layer 12 and the second semiconductor layer 13 having a band gap larger than that of the light absorbing layer 14, the dark current can be reduced. An i-type semiconductor layer (intrinsic semiconductor layer) may be provided between the first semiconductor layer 12 and the second semiconductor layer 13 to form a pin junction.

The light absorbing layer 14 between the second semiconductor layer 13 and the contact layer 15 is provided, for example, in common for all the pixels P. The light absorbing layer 14 absorbs light having a predetermined wavelength and generates signal charges, and includes, for example, a p-type compound semiconductor material. The compound semiconductor material constituting the light absorbing layer 14 includes, for example, a group III-V semiconductor containing at least any one of indium (In), gallium (Ga), aluminum (Al), arsenic (As), phosphorus (P), antimony (Sb), and nitrogen (N). Specific examples thereof include InGaAs (indium gallium arsenide), InGaAsP (indium gallium arsenide phosphide), InAsSb (indium arsenide antimony), InGaP (indium gallium phosphide), GaAsSb (gallium arsenide antimony), InAlAs (indium aluminum arsenide), and the like. The doping density of the light absorbing layer 14 is, for example, 1 × 10¹⁴ cm⁻³ to 1 × 10¹⁷ cm⁻³. As the doping density of the light absorbing layer 14 becomes higher than 1 × 10¹⁷ cm⁻³, the loss probability due to recombination of signal charges generated by photoelectric conversion increases, and the quantum efficiency decreases.

The thickness of the light absorbing layer 14 is, for example, 100 nm to 10,000 nm. As the thickness of the light absorbing layer 14 becomes less than 100 nm, the amount of light transmitted through the light absorbing layer 14 increases, and there is a possibility that the quantum efficiency is significantly reduced. As the thickness of the light absorbing layer 14 becomes larger than 5,000 nm, it becomes difficult to form the diffusion region D having a depth of 5,000 nm or more and to sufficiently suppress the occurrence of crosstalk between the adjacent pixels P. In the light absorbing layer 14, for example, light having a wavelength in a visible region to a short infrared region is photoelectrically converted.

The diffusion region D is, for example, a region in which p+-type impurities are diffused. The diffusion region D is provided for electrically separating the adjacent pixels P. The diffusion region D is provided in the sidewalls of the first semiconductor layer 12, the second semiconductor layer 13, and the light absorbing layer 14. In the plane direction (XY plane in Figs. 1 and 2) of the first semiconductor layer 12, the diffusion region D spreads around the first electrode 11 over the periphery of the first electrode 11. In the thickness direction (Z direction in Figs. 1 and 2) of the first semiconductor layer 12, the diffusion region D spreads from the first semiconductor layer 12 to the contact layer 15 through the second semiconductor layer 13 and the light absorbing layer 14. As described above, because the diffusion region D is provided so as to extend over the second semiconductor layer 13 and the light absorbing layer 14, the interface between the second semiconductor layer 13 and the light absorbing layer 14 in each pixel P is surrounded by the diffusion region D. Although the details will be described later, this forms a temporary retention part of the signal charges.

In the diffusion region D, for example, zinc (Zn) is diffused as the p+-type impurities. The p+-type impurities may be, for example, magnesium (Mg), cadmium (Cd), beryllium (Be), silicon (Si), germanium (Ge), carbon (C), tin (Sn), lead (Pb), sulfur (S), tellurium (Te), or the like. The doping density of the diffusion region D is higher than that of the first semiconductor layer 12, the second semiconductor layer, and the light absorbing layer 14. The doping density of the diffusion region D is, for example, 1 × 10¹⁷ cm⁻³ to 5 × 10¹⁹ cm⁻³. By setting the doping density of the diffusion region D to 1 × 10¹⁷ cm⁻³ or more, generation of the dark current at the interface is suppressed. Because the upper limit of the doping density, 5 × 10¹⁹ cm⁻³, is the upper limit obtained by the diffusion process and the doping density exceeding 5 × 10¹⁹ cm⁻³ is close to the solid solubility limit, dopants aggregate in the crystal to form defects and dark current characteristics deteriorate.

Furthermore, the widths of the two semiconductor layers (the first semiconductor layer 12 and the second semiconductor layer 13) excluding the diffusion region D in the sidewall in the plane direction (XY plane direction) are narrower than the width of the light absorbing layer 14 excluding the diffusion region D in the sidewall in the plane direction. In addition, the diffusion region D in the sidewall of each of the first semiconductor layer 12 and the second semiconductor layer 13 is thicker than the diffusion region D in the sidewall of the light absorbing layer 14. With this arrangement, as will be described later, a decrease in quantum efficiency can be suppressed, and an increase in the parasitic capacitance and the dark current can be suppressed.

The contact layer 15 is provided, for example, in common for all the pixels P. The contact layer 15 is provided between and in contact with the light absorbing layer 14 (second surface S2) and the second electrode 16. The contact layer 15 is a region where charges discharged from the second electrode 16 move, and includes, for example, a compound semiconductor containing p+-type impurities. For example, p+-type indium phosphide (InP) can be used for the contact layer 15. The contact layer 20 has the same conductivity type as that of the light absorbing layer 14. The doping density of the contact layer 15 is higher than that of the first semiconductor layer 12, the second semiconductor layer 13, and the light absorbing layer 14.

The second electrode 16 is provided on the second surface S2 (light incident surface) of the light absorbing layer 14 with the contact layer 15 interposed therebetween as, for example, an electrode common to the respective pixels P. The second electrode 16 is for discharging charges that are not used as signal charges among the charges generated in the light absorbing layer 14. For example, in a case where electrons are read out from the first electrode 11 as the signal charges, holes, for example, can be discharged through the second electrode 16. The second electrode 16 includes a transparent conductive film that can transmit the incident light such as infrared rays, and has a transmittance of 50% or more with respect to light having, for example, a wavelength of 1.6 um (1600 nm). As the second electrode 16, for example, indium tin oxide (ITO) or indium titanium oxide (ITiO) (In₂O₃-TiO₂), or the like can be used.

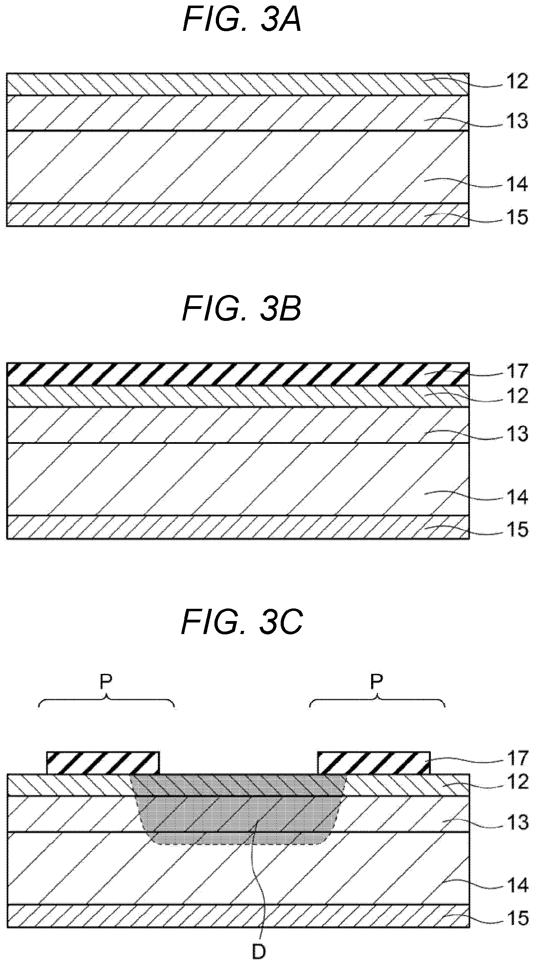

The insulating film 17 (first insulating film) is provided on the surface of the first semiconductor layer 12 for each pixel P. The insulating film 17 is for defining the diffusion region D, and functions as a mask in a diffusion step when the diffusion region D is formed as described later (see Fig. 3C described later). That is, the diffusion region D is formed between the adjacent insulating films 17. The thickness of the insulating film 17 is, for example, smaller than the thickness of the first electrode 11, such that the first electrode 11 protrudes from the insulating film 17. The thickness of the insulating film 17 is, for example, 10 nm to 5,000 nm. By using the insulating film 17 having a thickness of 10 nm or more, permeation of diffusion elements (impurities) in the diffusion step can be suppressed. As the thickness of the insulating film 17 becomes larger than 5,000 nm, there is a possibility that etching of the insulating film 17 at the time of forming the first electrode 11 becomes difficult.

For the insulating film 17, for example, an insulating material containing at least one of silicon (Si), nitrogen (N), aluminum (Al), hafnium (Hf), tantalum (Ta), titanium (Ti), magnesium (Mg), oxygen (O), lanthanum (La), gadolinium (Gd), or yttrium (Y) can be used. Specifically, for example, a silicon nitride (SiN) film can be used for the insulating film 17. For the insulating film 17, a silicon oxide (SiO₂) film, a silicon oxynitride (SiON) film, an aluminum oxynitride (AlON) film, a silicon aluminum nitride (SiAlN) film, a magnesium oxide (MgO), an aluminum oxide (Al₂O₃) film, a silicon aluminum oxide (AlSiO) film, a hafnium oxide (HfO₂) film, a hafnium aluminum oxide (HfAlO) film, or the like may be used. The insulating film 17 may include an organic material. As the organic material, a material that can suppress the transmission of the diffusion element is used.

The coating film 18 (second insulating film) covers the insulating film 17 and the sidewall surfaces of the first semiconductor layer 12, the second semiconductor layer 13, the light absorbing layer 14, and the contact layer 15. The coating film 18 is for protecting the sidewall surfaces of the first semiconductor layer 12, the second semiconductor layer 13, the light absorbing layer 14, and the contact layer 15. The coating film 18 includes, for example, an insulating material or a semiconductor material. For the insulating material constituting the coating film 18, for example, an insulating material containing at least one of silicon (Si), nitrogen (N), aluminum (Al), hafnium (Hf), tantalum (Ta), titanium (Ti), magnesium (Mg), scandium (Sc), zirconium (Zr), oxygen (O), lanthanum (La), gadolinium (Gd), or yttrium (Y) can be used. Specifically, the coating film 18 includes, for example, an aluminum oxide (Al₂O₃) film. The coating film 18 may include a silicon nitride (SiN) film, a silicon oxide (SiO₂) film, a silicon oxynitride (SiON) film, an aluminum oxynitride (AlON) film, a silicon aluminum nitride (SiAlN) film, magnesium oxide (MgO), an aluminum silicon oxide (AlSiO) film, a hafnium oxide (HfO₂) film, an aluminum hafnium oxide (HfAlO) film, a tantalum oxide (Ta₂O₃) film, a titanium oxide (TiO₂) film, a scandium oxide (Sc₂O₃) film, a zirconium oxide (ZrO₂) film, a gadolinium oxide (Gd₂O₃) film, a lanthanum oxide (La₂O₃) film, an yttrium oxide (Y₂O₃) film, or the like. Examples of the semiconductor material constituting the coating film 18 include, for example, group IV semiconductor materials such as silicon (Si) and germanium (Ge). The thickness of the coating film 18 is, for example, 1 nm to 500 nm. The lower limit of the thickness of the coating film 18 is not particularly limited, but is preferably 1 nm or more from the viewpoint of the deposition process in order to completely cover the exposed compound semiconductor. The upper limit of the thickness of the coating film 18 is not particularly limited, but is preferably 500 nm or less from the viewpoint of the subsequent formation of the first electrode 11 and planarization process. Note that the coating film 18 is not necessarily provided, and may be appropriately omitted.

The protective film 19 is provided so as to be laminated on the coating film 18. For the protective film 19, for example, an insulating material containing at least one of silicon (Si), nitrogen (N), aluminum (Al), hafnium (Hf), tantalum (Ta), titanium (Ti), magnesium (Mg), oxygen (O), lanthanum (La), gadolinium (Gd), or yttrium (Y) can be used. Specifically, the protective film 19 includes, for example, a silicon oxide (SiO₂) film. The protective film 19 may include, a silicon nitride (SiN) film, an aluminum oxide (Al₂O₃) film, a silicon oxynitride (SiON) film, an aluminum oxynitride (AlON) film, a silicon aluminum nitride (SiAlN) film, a magnesium oxide (MgO), a silicon aluminum oxide (AlSiO) film, a hafnium oxide (HfO₂) film, a hafnium aluminum oxide (HfAlO) film, or the like.

The first groove G1 is used for separating the pixels P. The first grooves G1 are disposed between the adjacent pixels P, and are provided in, for example, a lattice shape in plan view.

### [Manufacturing method of solid-state imaging element 1]

The solid-state imaging element 1 can be manufactured, for example, as follows. Figs. 3A to 3G illustrate manufacturing steps of the solid-state imaging element 1 in order of steps.

First, as illustrated in Fig. 3A, a laminated structure including the contact layer 15, the light absorbing layer 14, the second semiconductor layer 13, and the first semiconductor layer 12 in this order is formed by, for example, epitaxial growth. At this time, a pn junction is formed between the second semiconductor layer 13 and the first semiconductor layer 12.

Next, as illustrated in Fig. 3B, the insulating film 17 having a thickness of, for example, 10 nm or more is deposited on the entire surface of the first semiconductor layer 12. Subsequently, as illustrated in Fig. 3C, for example, photoresist and etching using a mask are performed. The etching is either dry etching or wet etching. Through this procedure, a part of the insulating film 17 is removed, and the surface of the first semiconductor layer 12 is exposed in a lattice shape. That is, the insulating film 17 is disposed in every pixel P.

After the surface of the first semiconductor layer 12 is exposed from the insulating film 17 in a lattice shape, as illustrated in Fig. 3C, the diffusion region D is formed using the insulating film 17 as a mask. The diffusion region D is formed by diffusing, for example, p+-type impurities such as zinc (Zn) from the exposed surface of the first semiconductor layer 12. The diffusion of impurities is performed by, for example, gas-phase diffusion or solid-phase diffusion. An impurity diffusion condition is set such that the diffusion region D is formed from the first semiconductor layer 12 to the inside of the light absorbing layer 14 through the second semiconductor layer 13. For example, the annealing temperature is adjusted to 300°C to 800°C.

Note that the diffusion region D may be formed up to the middle of the second semiconductor layer 13 without reaching the light absorbing layer 14. If the diffusion region D is formed deep in the light absorbing layer 14, there is a possibility that the quantum efficiency decreases. Therefore, the diffusion region D is preferably formed up to about the boundary surface between the second semiconductor layer 13 and the light absorbing layer 14.

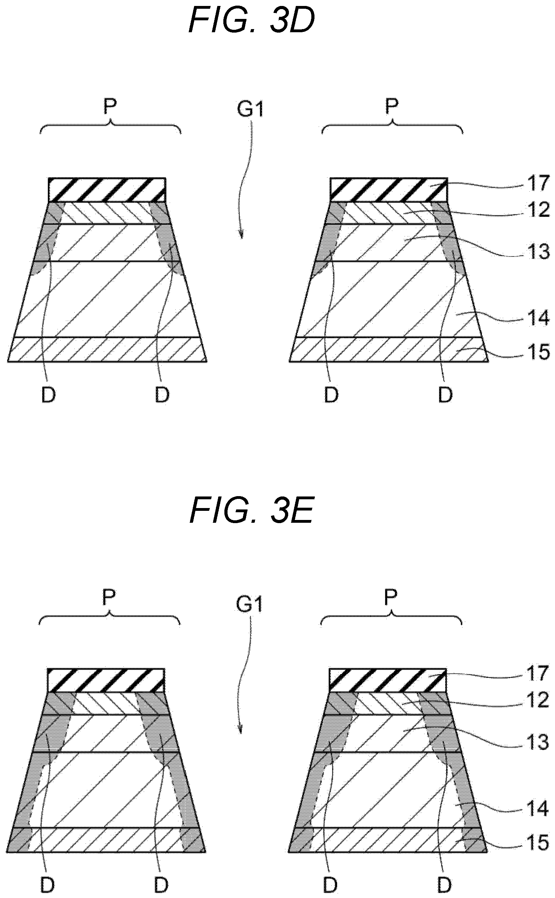

After the diffusion region D is formed, the first groove G1 is formed as illustrated in Fig. 3D. The first groove G1 exposes the diffusion region D in the sidewalls of the first semiconductor layer 12 and the second semiconductor layer 13, and the light absorbing layer 14. The first groove G1 is formed, for example, up to the contact layer 15. The first groove G1 is formed by, for example, dry etching or wet etching.

After the first groove G1 is formed, the second impurity diffusion step is performed as illustrated in Fig. 3E. The diffusion region D that has been formed in the first diffusion step spreads deeper into the first semiconductor layer 12 and the second semiconductor layer 13. In the second diffusion step, the diffusion region D is formed substantially simultaneously in the sidewalls of the light absorbing layer 14 and the contact layer 15. That is, the diffusion region D is formed in the sidewall of the light absorbing layer 14, and meanwhile, the diffusion region D in the sidewalls of the first semiconductor layer 12 and the second semiconductor layer 13 is made thicker than the diffusion region D in the sidewall of the light absorbing layer 14. Therefore, the thickness of the diffusion region D changes from the light absorbing layer 14 to the second semiconductor layer 13.

Note that the diffusion region D is formed slightly deeper in the contact layer 15 than in the light absorbing layer 14. That is, the diffusion region D formed in the sidewall of the contact layer 15 is thicker than the diffusion region D in the sidewall of the light absorbing layer 14, and thinner than the diffusion region D in the sidewalls of the first semiconductor layer 12 and the second semiconductor layer 13. This is because, for example, there is a case where the diffusion rate of impurities differs depending on the difference in the compound semiconductor material. In addition, in a case where the contact layer 15 is much thinner than the first semiconductor layer 12 and the second semiconductor layer 13, the diffusion region D in the sidewall of the contact layer 15 does not significantly affect deterioration in quantum efficiency.

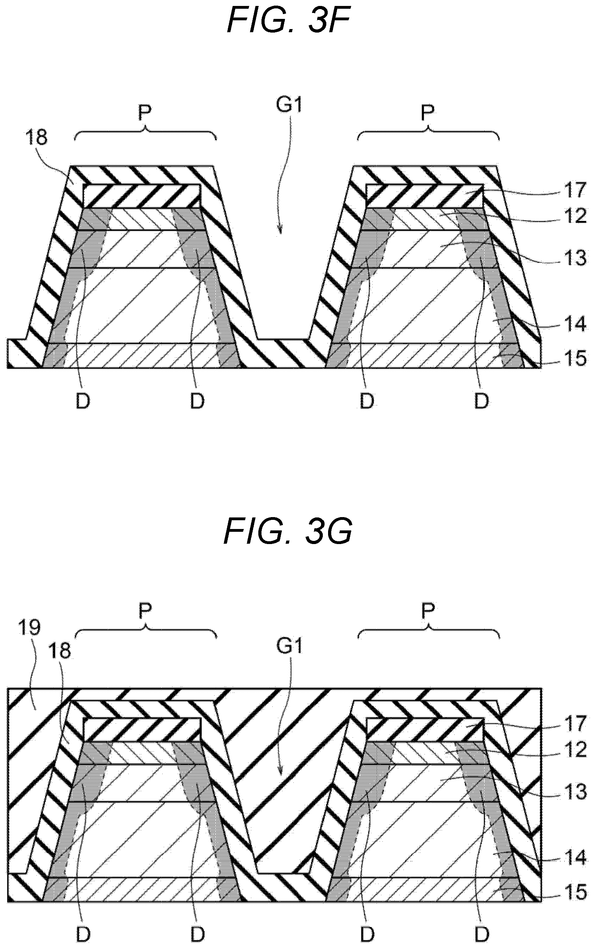

After the second diffusion step, as illustrated in Fig. 3F, the coating film 18 is formed on the entire sidewalls of the first semiconductor layer 12, the second semiconductor layer 13, the light absorbing layer 14, and the contact layer 15. The coating film 18 is deposited so as to cover the insulating film 17 together with the diffusion region D. The coating film 18 is formed by, for example, forming an insulating material using a thermal oxidation method, a chemical vapor deposition (CVD) method, an atomic layer deposition (ALD) method, or the like. The coating film 18 may be formed by depositing a semiconductor material by using a sputtering vapor deposition method, an electron beam gun vapor deposition method, a resistance heating vapor deposition method, the CVD method, the ALD method, or the like.

After the coating film 18 is formed, as illustrated in Fig. 3G, the protective film 19 is formed so as to cover the coating film 18.

After the protective film 19 is formed, for example, photoresist and etching using a mask are performed. The etching is either dry etching or wet etching. Through this procedure, a hole reaching the first semiconductor layer 12 is formed in the protective film 19, the coating film 18, and the insulating film 17. This hole is for forming the first electrode 11, and is formed at a position not overlapping with the diffusion region D in plan view.

After the hole is formed in the protective film 19, the coating film 18, and the insulating film 17, the first electrode 11 is formed in the hole. Finally, the second electrode 16 is formed on the lower surfaces of the contact layer 15 and the coating film 18. Through this procedure, the solid-state imaging element 1 illustrated in Fig. 1 is completed.

### [Operation of solid-state imaging element 1]

In the solid-state imaging element 1, when light L (for example, light having wavelengths in the visible region and the infrared region) enters the light absorbing layer 14 via the second electrode 16 and the contact layer 15, the light L is absorbed in the light absorbing layer 14. With this arrangement, in the light absorbing layer 14, pairs of holes and electrons are generated (photoelectric conversion occurs). At this time, for example, when a predetermined voltage is applied to the first electrode 11, a potential gradient is generated in the light absorbing layer 14, and one of the generated charges (for example, electrons) moves to the temporary retention part in the vicinity of the interface between the light absorbing layer 14 and the second semiconductor layer 13 as signal charges.

Because the band gap energy of the second semiconductor layer 13 is larger than that of the light absorbing layer 14, a band offset barrier is provided at the interface between the light absorbing layer 14 and the second semiconductor layer 13. Therefore, the movement of the signal charges from the light absorbing layer 14 to the second semiconductor layer 13 is temporarily prevented. Furthermore, because the diffusion region D is provided between the adjacent pixels P, the movement of the signal charges between the adjacent pixels P is also inhibited. Therefore, the signal charges are temporarily retained in the vicinity of the interface between the light absorbing layer 14 and the second semiconductor layer 13 and in a pocket-shaped portion surrounded by the diffusion region D. The signal charges pass over the band offset barrier from the temporary retention part and are collected to the first electrode 11 via the second semiconductor layer 13 and the first semiconductor layer 12. These signal charges are read out for each pixel P by a readout integrated circuit (ROIC).

As described above, according to the first embodiment, the diffusion region D can be controlled for every compound semiconductor layer by performing the diffusion step twice. With this arrangement, the diffusion region D in the sidewalls of the first semiconductor layer 12 and the second semiconductor layer 13 can be made thicker than the diffusion region D in the sidewall of the light absorbing layer 14.

In a case where the thickness of the diffusion region D is substantially the same regardless of the position, as the diffusion region D becomes thinner, the widths of the first semiconductor layer 12 and the second semiconductor layer 13 excluding the diffusion region D become wider. The depletion layer formed by the pn junction of the first semiconductor layer 12 and the second semiconductor layer 13 can be one of causes of the parasitic capacitance and the dark current. Therefore, as the diffusion region D becomes thinner, the parasitic capacitance and the dark current tend to increase. On the other hand, as the diffusion region D becomes thicker, the width of the light absorbing layer 14 excluding the diffusion region D becomes narrower, causing the quantum efficiency to decrease easily. That is, the parasitic capacitance and the dark current, and the quantum efficiency are in a trade-off relationship. For example, when the diffusion region D in the sidewalls of the first semiconductor layer 12 and the second semiconductor layer 13 is widened in order to reduce the parasitic capacitance, the diffusion region D in the sidewall of the light absorbing layer 14 is also widened. Therefore, the quantum efficiency decreases.

On the other hand, in the first embodiment, the increase in the parasitic capacitance and the dark current can be suppressed by making the diffusion region D in the sidewalls of the first semiconductor layer 12 and the second semiconductor layer 13 relatively thick, and the decrease in the quantum efficiency can be suppressed by making the diffusion region D of the sidewall of the light absorbing layer 14 relatively thin. That is, by controlling the thickness of the diffusion region D for every compound semiconductor layer, it is possible to achieve both of the low parasitic capacitance and the dark current, and the high quantum efficiency.

In addition, the thickness of the diffusion region D is determined from a depth of damage at the time of forming the first groove G1. If the damage at the time of forming the first groove G1 reaches the light absorbing layer 14, the dark current increases. Therefore, for example, in a case where the damaged layer is confirmed to be 200 nm, the diffusion region D having a thickness of 200 nm or more is formed. Note that the thickness of the diffusion region D is, for example, 100 nm or more.

In addition, the thickness of the diffusion region D in the sidewall of the first semiconductor layer 12 is preferably a thickness at which the diffusion region D is not in contact with the first electrode 11 from the viewpoint of reducing the dark current. That is, the diffusion region D in the sidewalls of the first semiconductor layer 12 and the second semiconductor layer 13 is disposed so as to be close to the first electrode 11 while being spaced apart from the first electrode 11. The thickness of the diffusion region D is controlled by, for example, adjusting the temperature and time of annealing.

In addition, as illustrated in Fig. 1, the width in the plane direction continuously decreases from the light incident surface (second surface S2) side of the light absorbing layer 14 including the diffusion region D in the sidewall to the first semiconductor layer 12 and the second semiconductor layer 13. For example, there is a case where the sidewall is inclined in a tapered shape depending on the condition of dry etching. Note that the widths of the first semiconductor layer 12 and the second semiconductor layer 13 in the plane direction including the diffusion region D in the sidewalls may be substantially the same as the width of the light absorbing layer 14 in the plane direction including the diffusion region D in the sidewall.

Furthermore, the first semiconductor layer 12 and the second semiconductor layer 13 have band gap energy larger than band gap energy of the light absorbing layer 14. With this arrangement, the depletion layer is formed in the vicinity of a portion between the first semiconductor layer 12 and the second semiconductor layer 13. Consequently, the generation of the dark current can be suppressed.

### <First modified example of first embodiment>

### [Configuration]

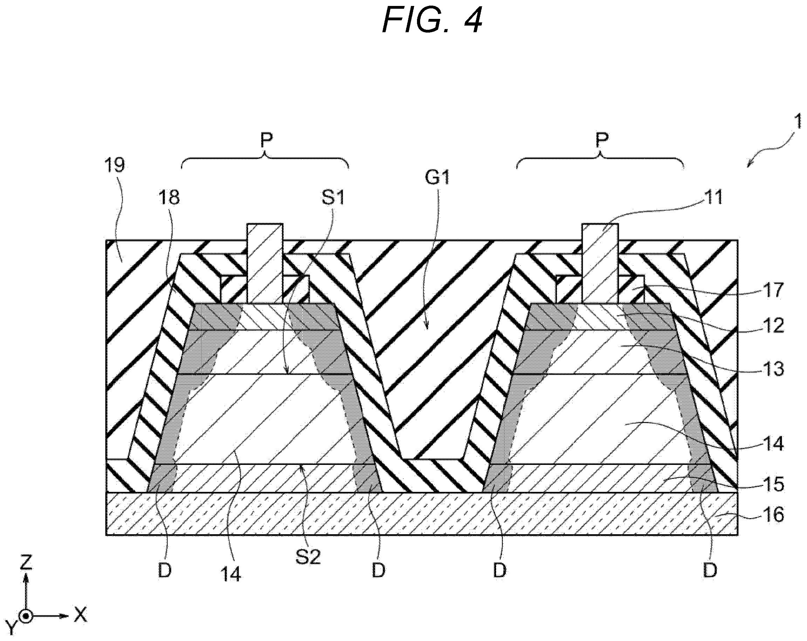

Fig. 4 illustrates a schematic cross-sectional configuration of the solid-state imaging element 1 according to a first modified example of the first embodiment described above. The first modified example of the first embodiment is different from the first embodiment in that the diffusion region D in the sidewall of the first semiconductor layer 12 is further thickened.

As compared with the first embodiment, a part of the outer peripheral part of the insulating film 17 is removed. That is, the insulating film 17 is disposed inside the first semiconductor layer 12 including the diffusion region D in the sidewall in plan view from the opposite side of the light incident surface (second surface S2).

The diffusion region D in the sidewall of the first semiconductor layer 12 is thicker than the diffusion region D in the sidewall of the second semiconductor layer 13. Therefore, in the second embodiment, an increase in parasitic capacitance and dark current can be further suppressed as compared with the first embodiment. Note that, similarly to the first embodiment, the diffusion region D in the sidewall of the second semiconductor layer 13 is thicker than the diffusion region D in the sidewall of the light absorbing layer 14.

Because other configurations of the solid-state imaging element 1 according to the first modified example of the first embodiment are similar to the corresponding configurations of the solid-state imaging element 1 according to the first embodiment, detailed description thereof will be omitted.

### [Manufacturing method of solid-state imaging element 1]

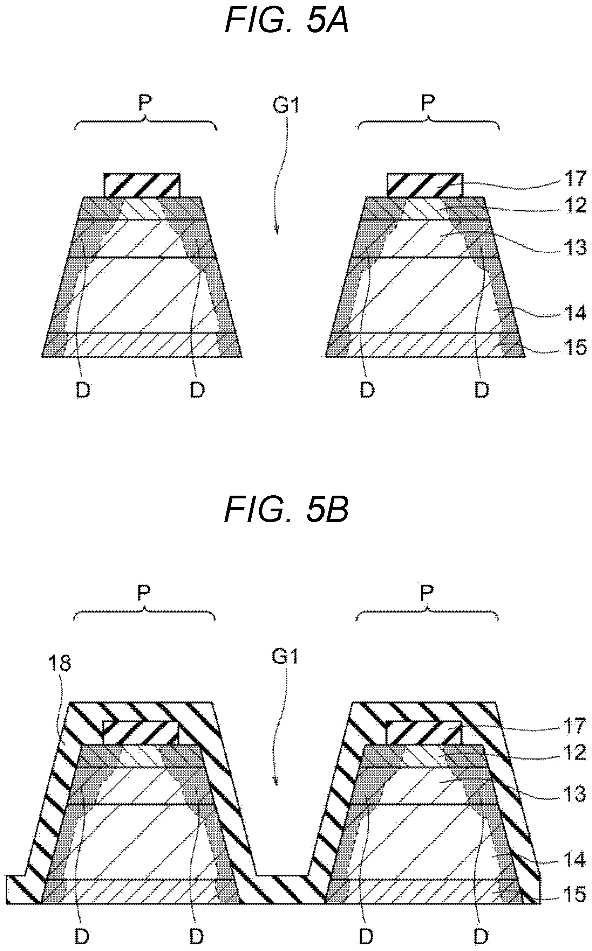

Figs. 5A to 5C illustrate manufacturing steps of the solid-state imaging element 1 in order of steps. Note that the steps before the step in Fig. 5A is the same as the steps in Figs. 3A to 3D described in the first embodiment.

First, a laminate structure is formed (see Fig. 3A). Next, the insulating film 17 is formed (see Fig. 3B). Next, a part of the insulating film 17 is removed to form the diffusion region D (see Fig. 3C).

After the first groove G1 is formed in the step in Fig. 3D, the outer peripheral part of the insulating film 17 is removed as illustrated in Fig. 5A. More specifically, the outer peripheral part of the insulating film 17 is removed such that the insulating film 17 is disposed inside the first semiconductor layer 12 and the second semiconductor layer 13 in plan view from the opposite side of the light incident surface (second surface S2) of the light absorbing layer 14. The outer peripheral part of the insulating film 17 is removed by, for example, dry etching.

After a part of the first insulating film is removed, the second diffusion step is performed using the insulating film 17 as a mask. The second diffusion step is substantially similar to the step in Fig. 3E. In Fig. 5A, as compared with Fig. 3E, the insulating film 17 functioning as a mask has a smaller area in plan view. Therefore, a part of the upper surface of the first semiconductor layer 12 is exposed from the insulating film 17. With this arrangement, impurities are easily diffused also from the upper surface of the first semiconductor layer 12. As a result, the diffusion region D in the sidewalls of the first semiconductor layer 12 can be made thicker than the diffusion region D in the sidewall of the second semiconductor layer 13.

After the second diffusion step, as illustrated in Fig. 5B, the coating film 18 is formed so as to cover the first semiconductor layer 12, the second semiconductor layer 13, the light absorbing layer 14, the contact layer 15, and the insulating film 17. The coating film 18 is formed in the similar manner as in Fig. 3F described in the first embodiment.

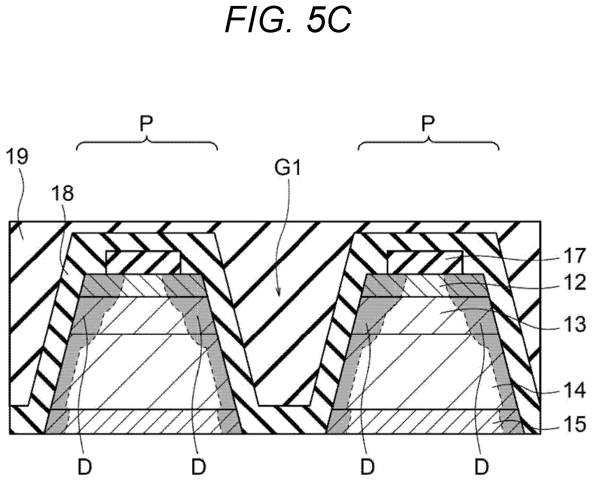

After the coating film 18 is formed, as illustrated in Fig. 5C, the protective film 19 is formed so as to cover the coating film 18. The protective film 19 is formed in the similar manner as in Fig. 3G described in the first embodiment.

After the protective film 19 is formed, the first electrode 11 and the second electrode 16 are formed as described in the first embodiment. Through this procedure, the solid-state imaging element 1 illustrated in Fig. 4 is completed. In addition, in the second embodiment, the diffusion region D is deeply spread in the first semiconductor layer 12 as compared with the first embodiment. The first electrode 11 needs to be narrowed in plan view so that the first electrode 11 does not come into contact with the diffusion region D.

As in the present modified example, a part of the outer peripheral part of the insulating film 17 may be etched to thicken the diffusion region D in the sidewall of the first semiconductor layer 12. Also in this case, the same effects as those of the first embodiment described above can be obtained.

### <Second modified example of first embodiment>

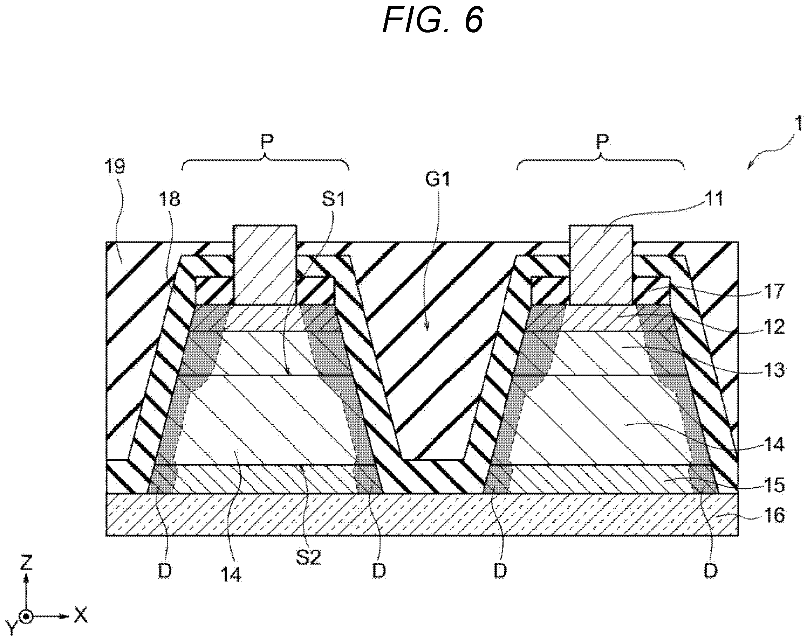

Fig. 6 illustrates a schematic cross-sectional configuration of the solid-state imaging element 1 according to a second modified example of the first embodiment described above. The second modified example of the first embodiment is different from the first embodiment in that the conductivity type is reversed.

The solid-state imaging element 1 in Fig. 1 described in the first embodiment has a p-type pixel, that is, an electronic readout structure. On the other hand, the solid-state imaging element 1 in Fig. 6 has a n-type pixel, that is, a hole readout structure. In addition, because the diffusion region D in Fig. 6 is the n-type, the dopant of the diffusion region D is, for example, silicon (Si), germanium (Ge), or the like.

As in the present modified example, holes may be read out as signal charges. Also in this case, the same effects as those of the first embodiment described above can be obtained. Note that the second modified example may be combined with the first modified example of the first embodiment.

### <Third modified example of first embodiment>

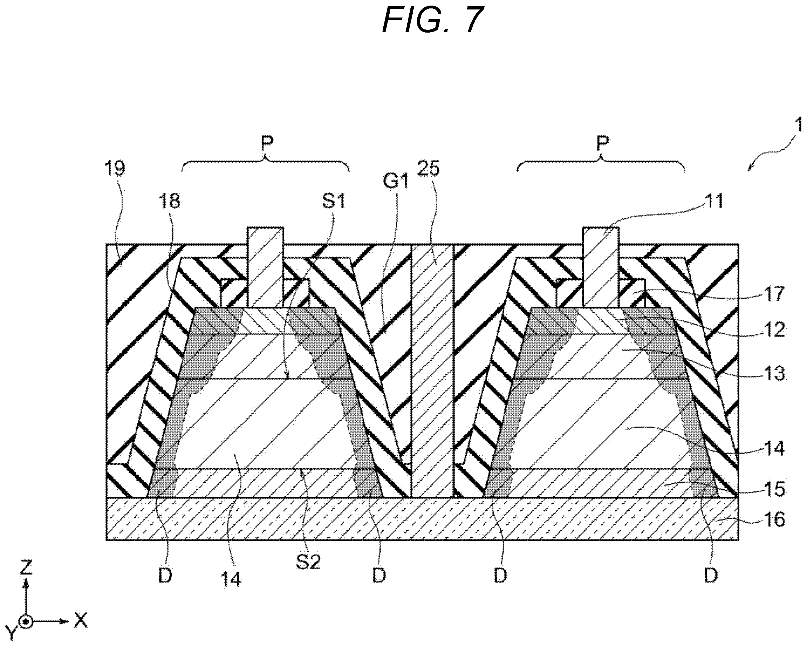

Fig. 7 illustrates a schematic cross-sectional configuration of the solid-state imaging element 1 according to a third modified example of the first embodiment described above. The third modified example of the first embodiment is different from the first modified example of the first embodiment in that a light-shielding member is provided.

The solid-state imaging element 1 further includes the light-shielding member (light-shielding member 25).

For example, the light-shielding member 25 is provided in a lattice shape in plan view, and is embedded in the first groove G1 from the surface of the protective film 19. The light-shielding member 25 is for optically separating the adjacent pixels P, and for example, the light-shielding member 25 can prevent obliquely incident light from entering the adjacent pixels P. Furthermore, for example, the light-shielding member 25 can suppress color mixing between the pixels P.

For the light-shielding member 25, for example, a material having low transmittance with respect to light having wavelengths in an infrared region and a visible region can be used. For example, the light-shielding member 25 includes a metal material having a transmittance of 10% or less with respect to light having a wavelength of 1 um. Specifically, as the light-shielding member 25, for example, any simple substance of titanium (Ti), tungsten (W), titanium nitride (TiN), platinum (Pt), gold (Au), copper (Cu), germanium (Ge), palladium (Pd), zinc (Zn), nickel (Ni), indium (In), and aluminum (Al), or an alloy containing at least one of the above substances and the like can be used.

In the example illustrated in Fig. 7, the upper end of the light-shielding member 25 is exposed from the protective film 19. The lower end of the light-shielding member 25 reaches the second electrode 16. Therefore, the light-shielding member 25 penetrates the coating film 18.

As in the present modified example, the light-shielding member 25 may be provided in the first groove G1. Also in this case, the same effects as those of the first modified example of the first embodiment described above can be obtained. Furthermore, the adjacent pixels P can be electrically separated by the diffusion region D, and also the adjacent pixels P can be optically separated by the light-shielding member 25. Therefore, the occurrence of crosstalk between the pixels P can be more effectively suppressed. Note that the light-shielding member 25 may be provided not only in the first embodiment and the modified example thereof but also in the second embodiment and the modified example thereof.

### <Fourth modified example of first embodiment>

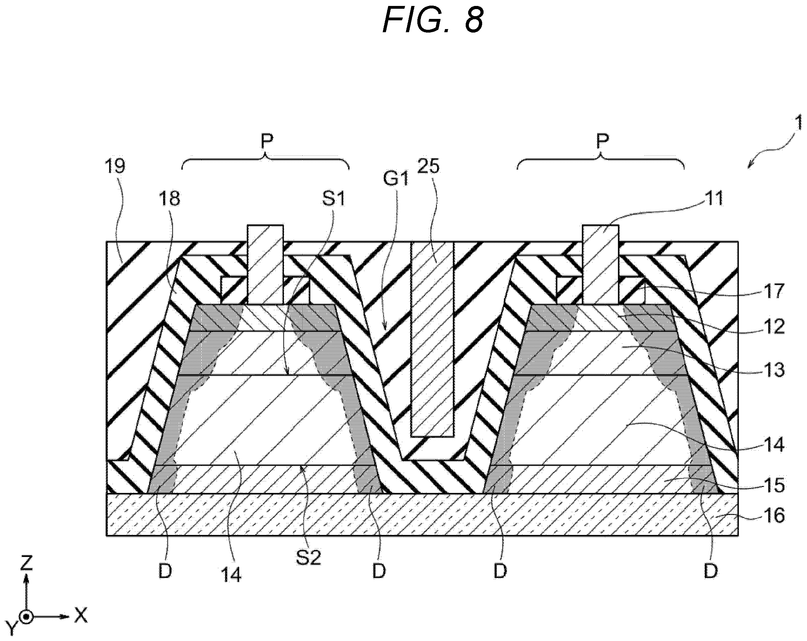

Fig. 8 illustrates a schematic cross-sectional configuration of the solid-state imaging element 1 according to a fourth modified example of the first embodiment described above. The fourth modified example of the first embodiment is different from the third modified example of the first embodiment in that the light-shielding member 25 is disposed in a different manner.

In the example illustrated in Fig. 8, the upper end of the light-shielding member 25 is exposed from the protective film 19 similarly to that in Fig. 7. The lower end of the light-shielding member 25 is located inside the protective film 19 without reaching the coating film 18. Therefore, the light-shielding member 25 may not penetrate the coating film 18.

As in the present modified example, the position of the light-shielding member 25 may be changed. Also in this case, the same effects as those of the third modified example of the first embodiment described above can be obtained.

### <Fifth modified example of first embodiment>

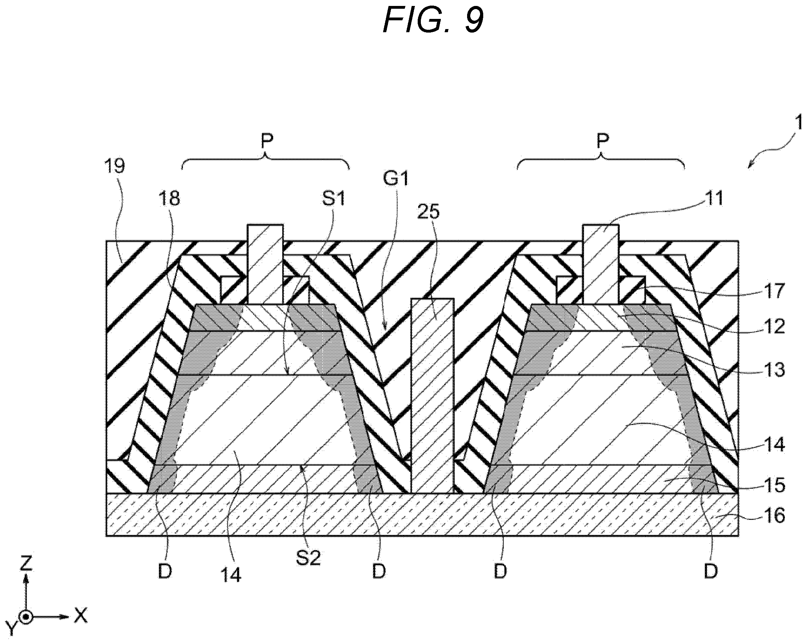

Fig. 9 illustrates a schematic cross-sectional configuration of the solid-state imaging element 1 according to a fifth modified example of the first embodiment described above. The fifth modified example of the first embodiment is different from the third modified example of the first embodiment in that the light-shielding member 25 is disposed in a different manner.

In the example illustrated in Fig. 9, the upper end of the light-shielding member 25 is located inside the protective film 19 and is not exposed from the surface of the protective film 19. The lower end of the light-shielding member 25 reaches the second electrode 16 similarly to that in Fig. 7.

As in the present modified example, the position of the light-shielding member 25 may be changed. Also in this case, the same effects as those of the third modified example of the first embodiment described above can be obtained.

### <Sixth modified example of first embodiment>

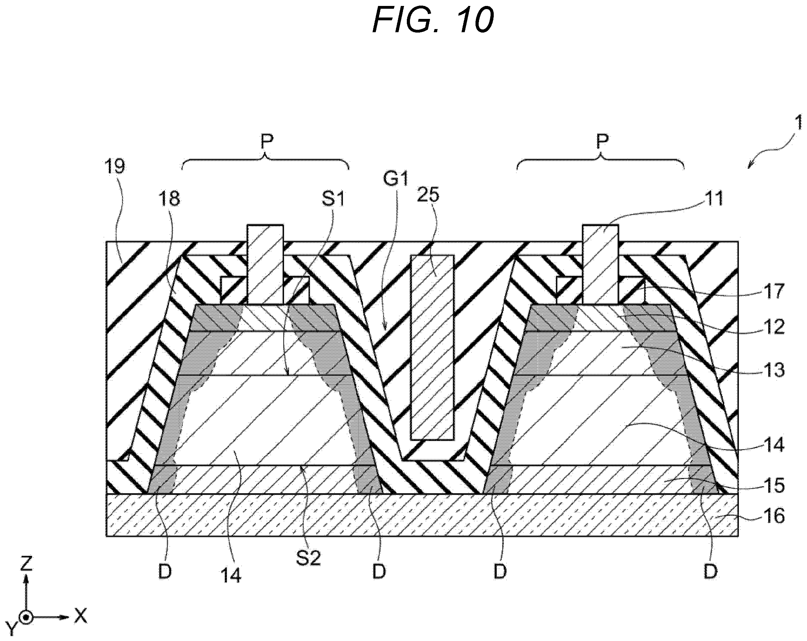

Fig. 10 illustrates a schematic cross-sectional configuration of the solid-state imaging element 1 according to a sixth modified example of the first embodiment described above. The sixth modified example of the first embodiment is different from the third modified example of the first embodiment in that the light-shielding member 25 is disposed in a different manner.

In the example illustrated in Fig. 10, both the upper end and the lower end of the light-shielding member 25 are located inside the protective film 19.

As in the present modified example, the position of the light-shielding member 25 may be changed. Also in this case, the same effects as those of the third modified example of the first embodiment described above can be obtained.

### <Second embodiment>

### [Configuration]

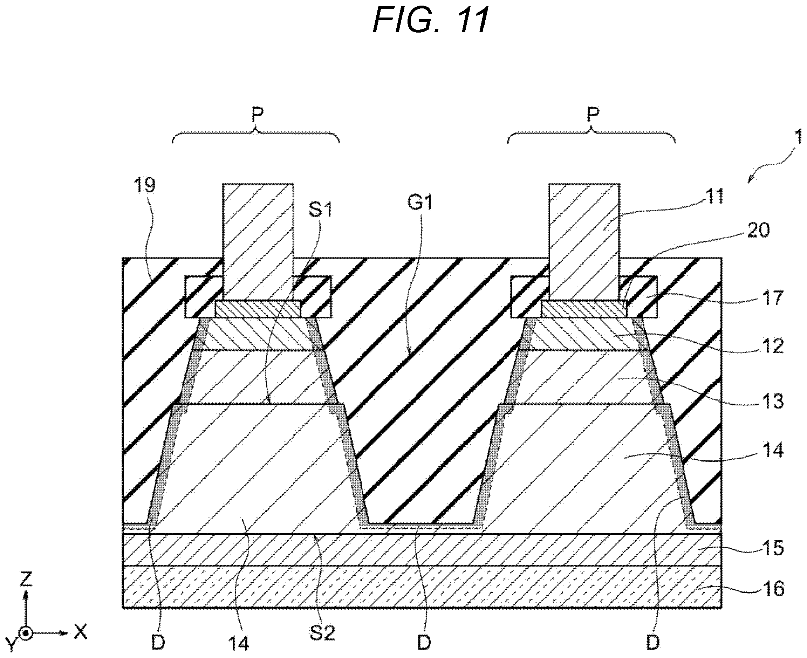

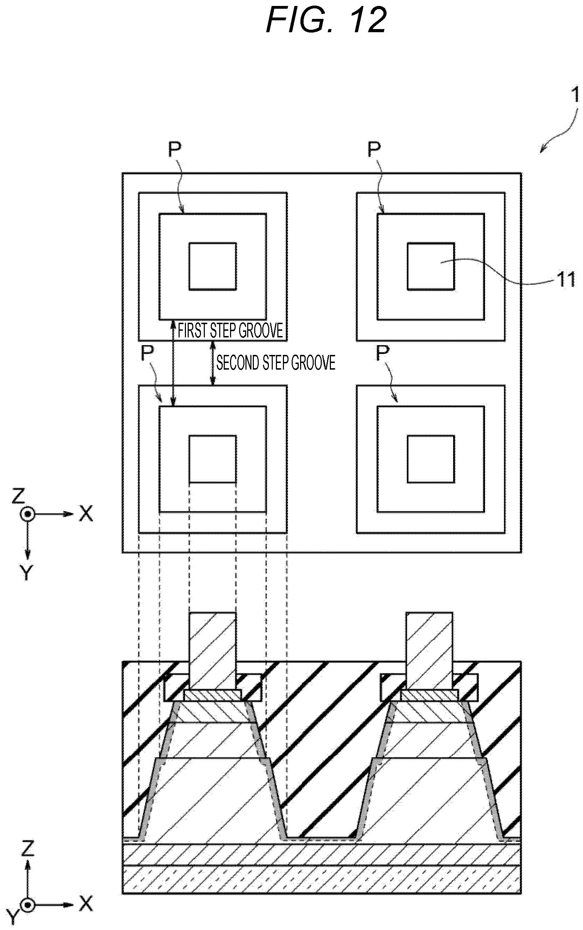

Figs. 11 and 12 illustrate a schematic configuration of a solid-state imaging element 1 according to a second embodiment of the present disclosure. Fig. 11 illustrates a cross-sectional configuration of the solid-state imaging element 1, and Fig. 12 illustrates a planar configuration of the solid-state imaging element 1. The second embodiment is different from the first embodiment in that a part of the sidewalls of a first semiconductor layer 12 and a second semiconductor layer 13 are removed and the widths thereof are narrowed. Furthermore, the thickness of a diffusion region D is substantially the same depending on the position.

The widths of the first semiconductor layer 12 and the second semiconductor layer 13 in the plane direction including the diffusion region D in the sidewalls is narrowed gradually (stepwise) from the width of a light absorbing layer 14 including the diffusion region D in the sidewall.

In addition, as illustrated in Figs. 11 and 12, a step of the bottom part of a first groove G1 and a step of a first surface S1 are provided.

The thickness of the diffusion region D is substantially the same for every one of the first semiconductor layer 12, the second semiconductor layer 13, and the light absorbing layer 14. That is, the diffusion region D in the sidewalls of the first semiconductor layer 12 and the second semiconductor layer 13 has substantially the same thickness as the diffusion region D in the sidewall of the light absorbing layer 14. Note that the thicknesses of the diffusion regions D described above are not necessarily equal to each other, and for example, the thicknesses of the diffusion regions D may be different depending on a difference in diffusion rate of impurities for each compound semiconductor material.

Furthermore, the solid-state imaging element 1 according to the second embodiment further includes a contact layer 20. The contact layer 20 is provided, for example, in common for all pixels P. The contact layer 20 is provided between and in contact with a first electrode 11 and a first semiconductor layer 12. The contact layer 20 is a region where charges collected to the first electrode 11 move, and includes, for example, a compound semiconductor containing n+-type impurities. For example, n+-type indium phosphide (InP) can be used for the contact layer 20. By providing the contact layer 20, contact resistance can be reduced. Note that the contact layer 20 is not necessarily provided.

Because other configurations of the solid-state imaging element 1 according to the second embodiment are similar to the corresponding configurations of the solid-state imaging element 1 according to the first embodiment, detailed description thereof will be omitted.

### [Manufacturing method of solid-state imaging element 1]

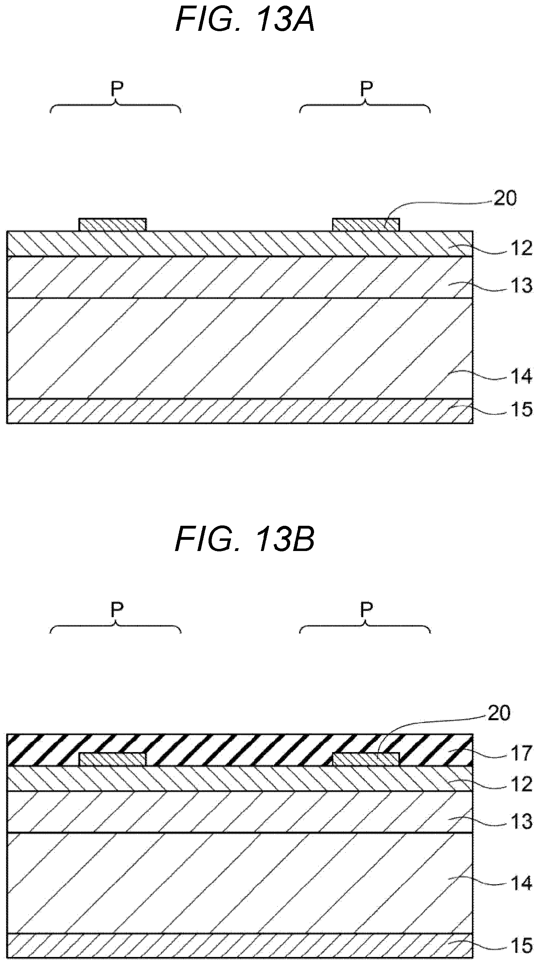

Figs. 13A to 13E illustrate manufacturing steps of the solid-state imaging element 1 in order of steps.

First, as illustrated in Fig. 13A, a laminated structure including a contact layer 15, the light absorbing layer 14, the second semiconductor layer 13, the first semiconductor layer 12, and the contact layer 20 in this order is formed by, for example, epitaxial growth. At this time, a pn junction is formed between the second semiconductor layer 13 and the first semiconductor layer 12. Next, for example, photoresist and etching using a mask are performed. The etching is either dry etching or wet etching. Through this procedure, a part of the contact layer 20 is removed, and the surface of the first semiconductor layer 12 is exposed in a lattice shape. Through this procedure, the structure illustrated in Fig. 13A is obtained. That is, the contact layer 20 is disposed in every pixel P.

Next, as illustrated in Fig. 13B, an insulating film 17 is formed so as to cover the surface of the first semiconductor layer 12 and the contact layer 20.

The insulating film 17 is more preferably an insulating film such as an oxide film suitable for the first semiconductor layer 12 (for example, InP).

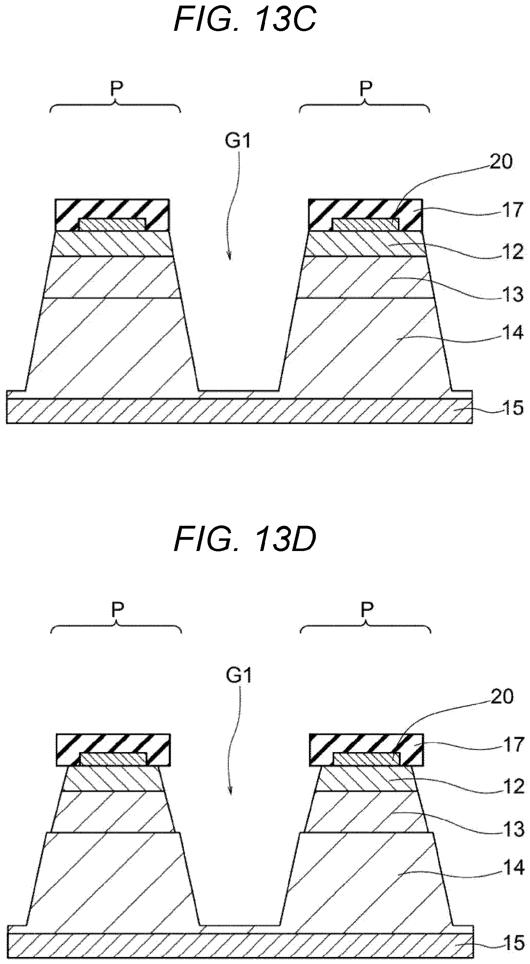

After the insulating film 17 is formed, as illustrated in Fig. 13C, the first groove G1 for separating the pixels P is formed. For example, photoresist and etching using a mask are performed. As the etching, for example, dry etching is used. Through this procedure, the first groove G1 is formed in the insulating film 17, the first semiconductor layer 12, the second semiconductor layer 13, and the light absorbing layer 14. The first groove G1 may be formed up to the middle of the light absorbing layer 14 or may penetrate to the contact layer 15.

After the first groove G1 is formed, as illustrated in Fig. 13D, a part of exposed sidewalls of the first semiconductor layer 12 and the second semiconductor layer 13 is etched. That is, the first semiconductor layer 12 and the second semiconductor layer 13 are removed by a predetermined distance from the sidewalls of the first semiconductor layer 12 and the second semiconductor layer 13. Through this procedure, a two-step shape in which the width changes stepwise between the first semiconductor layer 12 and the second semiconductor layer 13 and the light absorbing layer 14 is obtained. For example, wet etching using an etching solution for InP in which a selection ratio between InP of the first semiconductor layer 12 and the second semiconductor layer 13 and InGaAs of the light absorbing layer 14 can be obtained is used for the etching. At the time of the wet etching, a damaged layer (defect layer) on the sidewall generated by the dry etching for forming the first groove G1 can be removed. In addition, the amount of etching needs to be controlled so that the first semiconductor layer 12 and the second semiconductor layer 13 become wider than the contact layer 20. This is to prevent the diffusion region D to be formed later from coming into contact with the contact layer 20.

Note that, by wet-etching the sidewall of the light absorbing layer 14, a damaged layer on the sidewall of the light absorbing layer 14 generated by the dry etching can be removed. However, due to the two-step shape described above, the etching width of the light absorbing layer 14 needs to be made smaller than the etching widths of the first semiconductor layer 12 and the second semiconductor layer 13.

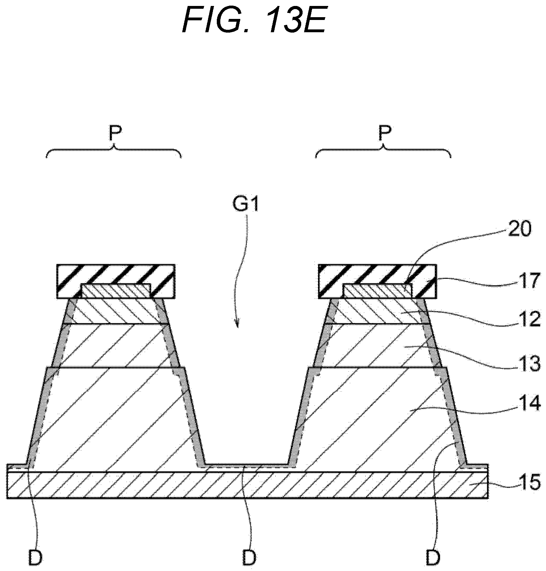

After the two-step shape is formed, the diffusion region D is formed as illustrated in Fig. 13E. The diffusion region D is formed in the sidewalls of the first semiconductor layer 12, the second semiconductor layer 13, and the light absorbing layer 14. The diffusion region D is formed by diffusing, for example, p+-type impurities such as zinc (Zn) from the exposed surface of the first semiconductor layer 12. The diffusion of impurities is performed by, for example, gas-phase diffusion or solid-phase diffusion. If the diffusion region D is made too thick, there is a case where the quantum efficiency decrease. In addition, in a case where the damaged layer remains at the time of processing the sidewalls, diffusion of impurities is required to cover the entire damaged layer in order to suppress an increase in dark current. Therefore, the thickness of the diffusion region D is set in consideration of the quantum efficiency and the dark current. In addition, when the diffusion region D in the sidewall of the first semiconductor layer 12 is connected to the contact layer 20, the dark current possibly increases. Therefore, the amount of etching of the first semiconductor layer 12 and the thickness of the diffusion region D needs to be controlled to such an extent that the diffusion region D in the sidewall of the first semiconductor layer 12 does not come into contact with the contact layer 20.

After the diffusion region D is formed, a protective film 19 is formed so as to cover the insulating film 17 and the diffusion region D. Next, for example, photoresist and etching using a mask are performed. The etching is either dry etching or wet etching. Through this procedure, a hole reaching the contact layer 20 is formed in the protective film 19 and the insulating film 17. After the hole is formed, the first electrode 11 is formed in the hole. Finally, a second electrode 16 is formed on the entire surface of the contact layer 15. Through this procedure, the solid-state imaging element 1 illustrated in Fig. 11 is completed.

As described above, according to the second embodiment, by making the widths of the first semiconductor layer 12 and the second semiconductor layer 13 including the diffusion region D in the sidewalls narrower than the width of the light absorbing layer 14, the sidewalls are separated into two steps. In addition, the diffusion region D is formed in the sidewalls in both of the two steps. With this arrangement, the diffusion region D can be formed deeper in the first semiconductor layer 12 and the second semiconductor layer 13 than in the light absorbing layer 14.

In a case where the widths including the diffusion region D in the sidewalls are substantially the same between the first semiconductor layer 12 and the second semiconductor layer 13 and the light absorbing layer 14, as the diffusion region D becomes thinner, the widths of the first semiconductor layer 12 and the second semiconductor layer 13 excluding the diffusion region D become wider. The depletion layer formed by the pn junction of the first semiconductor layer 12 and the second semiconductor layer 13 can be one of causes of the parasitic capacitance and the dark current. Therefore, as the diffusion region D becomes thinner, the parasitic capacitance and the dark current tend to increase. On the other hand, as the diffusion region D becomes thicker, the width of the light absorbing layer 14 excluding the diffusion region D becomes narrower, causing the quantum efficiency to decrease easily.

On the other hand, in the second embodiment, the parasitic capacitance and the dark current can be reduced by narrowing the widths of the first semiconductor layer 12 and the second semiconductor layer 13 by etching or the like. Therefore, the diffusion region D does not need to be thickened in order to reduce the parasitic capacitance and the dark current. Furthermore, the amount of etching of the light absorbing layer 14 can be reduced by selective etching, and the light absorbing layer 14 can be kept wide. That is, by controlling the thickness in the plane direction for every compound semiconductor layer, it is possible to achieve both of the low parasitic capacitance and the dark current, and the high quantum efficiency.

Furthermore, as described in the step in Fig. 13D, the damaged layer on the grooved surface can be removed by wet etching. From the viewpoint of removing the damaged layer, the dark current can be further suppressed.

In addition, the thickness of the diffusion region D in the sidewall of the first semiconductor layer 12 is preferably a thickness at which the diffusion region D is not in contact with the contact layer 20 from the viewpoint of reducing the dark current. That is, the diffusion region D in the sidewalls of the first semiconductor layer 12 and the second semiconductor layer 13 is disposed so as to be close to the contact layer 20 while being spaced apart from the contact layer 20. The thickness of the diffusion region D is controlled by, for example, adjusting the temperature and time of annealing.

### <First modified example of second embodiment>

### [Configuration]

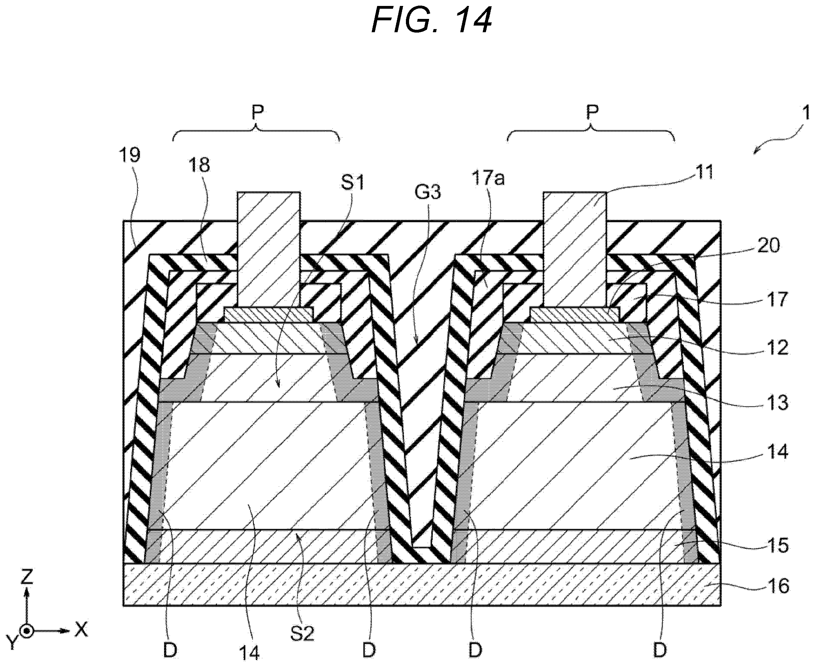

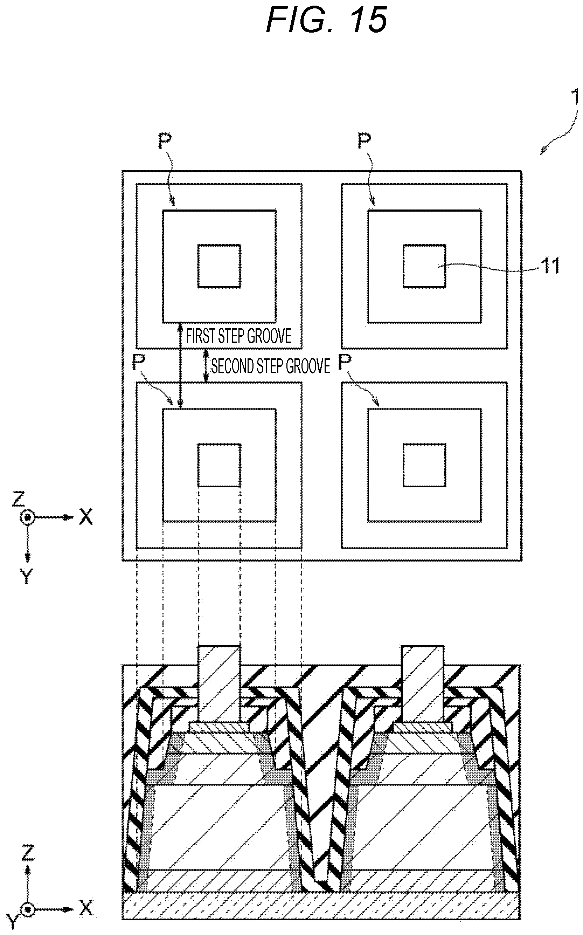

Figs. 14 and 15 illustrate a schematic cross-sectional configuration of the solid-state imaging element 1 according to a first modified example of the second embodiment described above. Fig. 14 illustrates a cross-sectional configuration of the solid-state imaging element 1, and Fig. 15 illustrates a planar configuration of the solid-state imaging element 1. The first modified example of the second embodiment is different from the second embodiment in that the thickness of the diffusion region D varies depending on the position.

Furthermore, as illustrated in Figs. 14 and 15, a step of the bottom part of a third groove G3 and a step parallel with the XY plane in the second semiconductor layer 13 are provided.

The diffusion region D in the sidewalls of the first semiconductor layer 12 and the second semiconductor layer 13 is thicker than the diffusion region D in the sidewall of the light absorbing layer 14. Therefore, in the second embodiment, the parasitic capacitance and the dark current can be further suppressed as compared with the first embodiment.

In comparison to the second embodiment, the insulating film 17 is provided so as to cover the diffusion region D in the sidewalls of the first semiconductor layer 12 and the second semiconductor layer 13. More specifically, an insulating film 17a is additionally provided so as to cover the insulating film 17 and the sidewalls of the first semiconductor layer 12 and the second semiconductor layer 13. The material of the insulating film 17a is, for example, the same material as the insulating film 17.

A coating film 18 is provided so as to cover the diffusion region D in the sidewall of the light absorbing layer 14. Therefore, because the first semiconductor layer 12 and the second semiconductor layer 13 are covered with the insulating film 17a, these two layers are not covered with the coating film 18.

Because other configurations of the solid-state imaging element 1 according to the first modified example of the second embodiment are similar to the corresponding configurations of the solid-state imaging element 1 according to the second embodiment, detailed description thereof will be omitted.

### [Manufacturing method of solid-state imaging element 1]

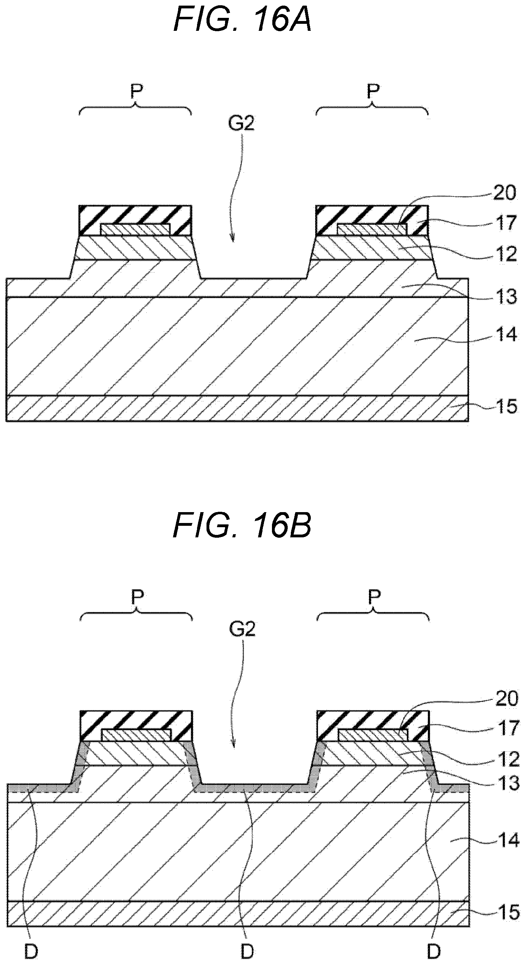

Figs. 16A to 16E illustrate manufacturing steps of the solid-state imaging element 1 in order of steps. Note that the steps before the step in Fig. 16A is the same as the steps in Figs. 13A to 13B described in the second embodiment.

First, a laminate structure is formed, and a part of the contact layer 20 is removed (see Fig. 13 A).

After the insulating film 17 is formed in the step in Fig. 13B, a second groove G2 is formed as illustrated in Fig. 16A. The second groove G2 exposes the sidewalls of the first semiconductor layer 12 and the second semiconductor layer 13. For example, photoresist and etching using a mask are performed. As the etching, for example, dry etching is used. Through this procedure, the second groove G2 is formed in the insulating film 17, the first semiconductor layer 12, and the second semiconductor layer 13. The second groove G2 is formed, for example, up to the middle of the second semiconductor layer 13.

After the second groove G2 is formed, the diffusion region D is formed using the insulating film 17 as a mask as illustrated in Fig. 16B. The diffusion region D is formed in the sidewalls of the first semiconductor layer 12 and the second semiconductor layer 13. In addition, when the diffusion region D in the sidewall of the first semiconductor layer 12 is connected to the contact layer 20, the dark current possibly increases. Therefore, the amount of etching of the first semiconductor layer 12 and the thickness of the diffusion region D needs to be controlled to such an extent that the diffusion region D in the sidewall of the first semiconductor layer 12 does not come into contact with the contact layer 20.

The first diffusion step is more preferably performed, for example, in a phosphine (PH₃) atmosphere. This is because the light absorbing layer 14 is not exposed, and the first semiconductor layer 12 and the second semiconductor layer 13 are exposed on the surface. As a result, desorption of phosphorus (P) or the like in the first semiconductor layer 12 and the second semiconductor layer 13 (for example, InP) exposed on the surface is suppressed.

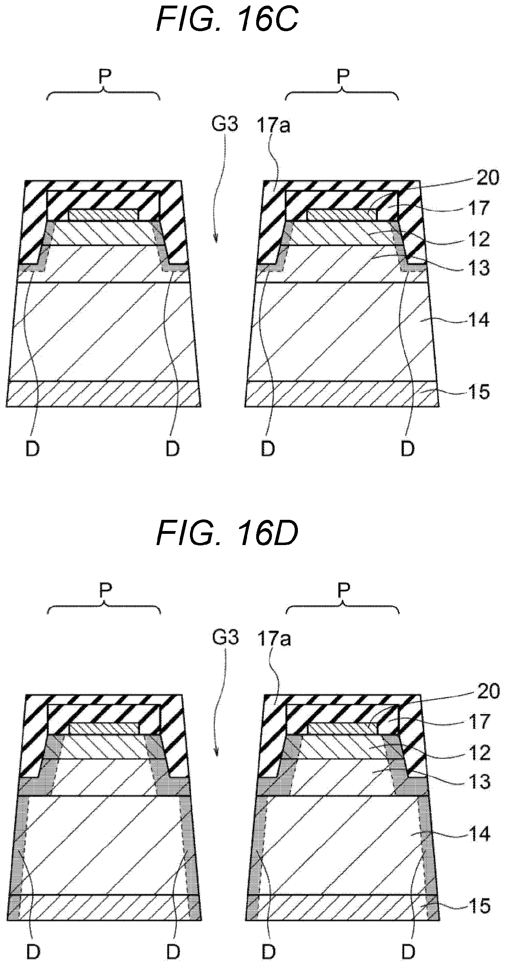

After the diffusion region D is formed, as illustrated in Fig. 16C, the third groove G3 is formed after adding the insulating film 17a.

The insulating film 17a is formed so as to cover the diffusion region D in the sidewalls of the first semiconductor layer 12 and the second semiconductor layer 13. The insulating film 17a is more preferably an insulating film such as an oxide film suitable for the first semiconductor layer 12 and the second semiconductor layer 13 (for example, InP). This is because the insulating film 17a is in contact with the first semiconductor layer 12 and the second semiconductor layer 13 without being in contact with the light absorbing layer 14. The material of the insulating film 17a is, for example, the same material as the insulating film 17.

The third groove G3 exposes the sidewall of the light absorbing layer 14. For example, photoresist and etching using a mask are performed. As the etching, for example, dry etching is used. Through this procedure, the third groove G3 is formed in the second semiconductor layer 13, the light absorbing layer 14, and the contact layer 15. The third groove G3 may be formed up to the middle of the light absorbing layer 14 or may penetrate to the contact layer 15.

Furthermore, the third groove G3 is narrower than the second groove G2. With this arrangement, the widths of the first semiconductor layer 12 and the second semiconductor layer 13 including the diffusion region D in the sidewalls can be made narrower than the width of the light absorbing layer 14 including the diffusion region D in the sidewall.

After the third groove G3 is formed, the second impurity diffusion step is performed as illustrated in Fig. 16D. The diffusion region D that has been formed in the first diffusion step spreads deeper into the first semiconductor layer 12 and the second semiconductor layer 13. In the second diffusion step, the diffusion region D is formed substantially simultaneously in the sidewalls of the light absorbing layer 14 and the contact layer 15. Through this procedure, the diffusion region D formed in the first semiconductor layer 12 and the second semiconductor layer 13 becomes thicker than the diffusion region D formed in the light absorbing layer 14 and the contact layer 15.

If the diffusion region D is made too thick, the quantum efficiency decreases. In addition, in a case where the damaged layer remains at the time of processing the sidewalls, diffusion of impurities is required to cover the entire damaged layer in order to suppress an increase in dark current. Therefore, the thickness of the diffusion region D in the first and second diffusion steps is set in consideration of the quantum efficiency and the dark current. In addition, when the diffusion region D in the sidewall of the first semiconductor layer 12 is connected to the contact layer 20, the dark current possibly increases. Therefore, the amount of etching of the first semiconductor layer 12 and the thickness of the diffusion region D needs to be controlled to such an extent that the diffusion region D in the sidewall of the first semiconductor layer 12 does not come into contact with the contact layer 20.

The second diffusion step is performed, for example, in an arsine (AsH₃) atmosphere. This is because the sidewalls of the first semiconductor layer 12 and the second semiconductor layer 13 are already covered with the insulating film 17a, and most of the compound semiconductor layer exposed on the sidewall surface is the light absorbing layer 14. As a result, desorption or the like of arsenic (As) in the light absorbing layer 14 (for example, InGaAs) exposed on the surface can be suppressed.

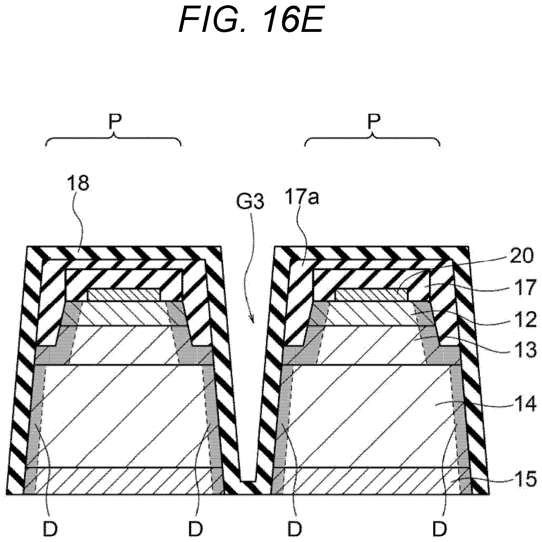

After the second diffusion step, as illustrated in Fig. 16E, the coating film 18 is formed so as to cover the insulating film 17a, the second semiconductor layer 13, the light absorbing layer 14, and the contact layer 15. The coating film 18 is provided so as to cover the diffusion region D in the sidewall of the light absorbing layer 14.

The coating film 18 is more preferably an insulating film such as an oxide film suitable for the light absorbing layer 14 (for example, InGaAs). This is because the sidewalls of the first semiconductor layer 12 and the second semiconductor layer 13 are already covered with the insulating film 17a, and most of the compound semiconductor layer among the sidewall surface exposed from the insulating film 17a is the light absorbing layer 14. Therefore, the coating film 18 includes, for example, a material different from the insulating film 17a.

After the coating film 18 is formed, the protective film 19 is formed so as to cover the coating film 18. Next, as described in the second embodiment, the first electrode 11 and the second electrode 16 are formed. Through this procedure, the solid-state imaging element 1 illustrated in Fig. 14 is completed.

As in the present modified example, the width and the diffusion region D may be controlled for each compound semiconductor by forming the width of the semiconductor layer into a two-step shape and performing the diffusion step twice. Also in this case, the same effects as those of the first and second embodiments described above can be obtained.

In addition, as illustrated in Fig. 14, the insulating film 17a and the coating film 18 suitable for each of InP of the first semiconductor layer 12 and the second semiconductor layer 13 and InGaAs of the light absorbing layer 14 can be deposited. The dark current can be further suppressed also from the viewpoint that an appropriate insulating film for every material can be deposited.

### <Second modified example of second embodiment>

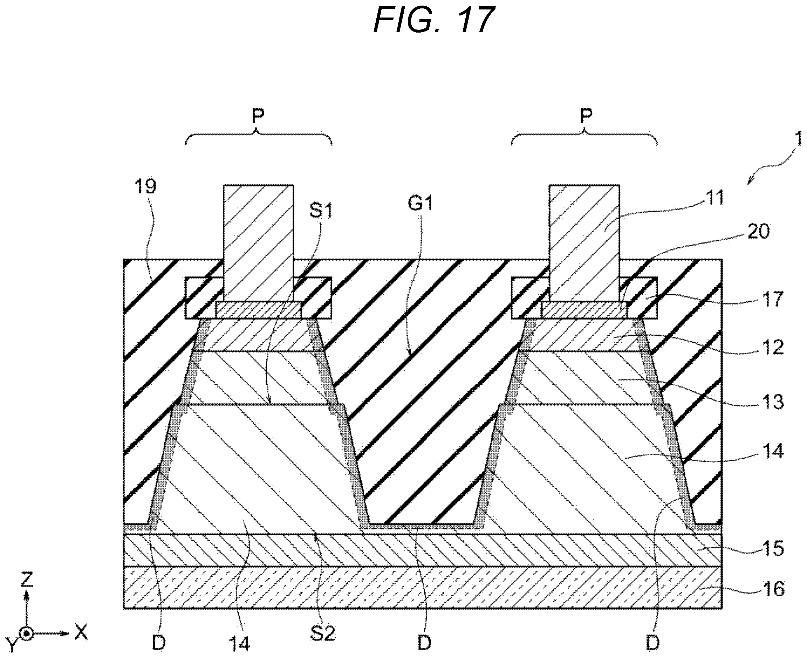

Fig. 17 illustrates a schematic cross-sectional configuration of the solid-state imaging element 1 according to a second modified example of the second embodiment described above. The second modified example of the second embodiment is different from the second embodiment in that the conductivity type is reversed.

The solid-state imaging element 1 in Fig. 11 described in the second embodiment has a p-type pixel, that is, an electronic readout structure. On the other hand, the solid-state imaging element 1 in Fig. 17 has a n-type pixel, that is, a hole readout structure. In addition, because the diffusion region D in Fig. 17 is the n-type, the dopant of the diffusion region D is, for example, silicon (Si), germanium (Ge), or the like.

As in the present modified example, holes may be read out as signal charges. Also in this case, the same effects as those of the first embodiment described above can be obtained.

### <Third modified example of second embodiment>

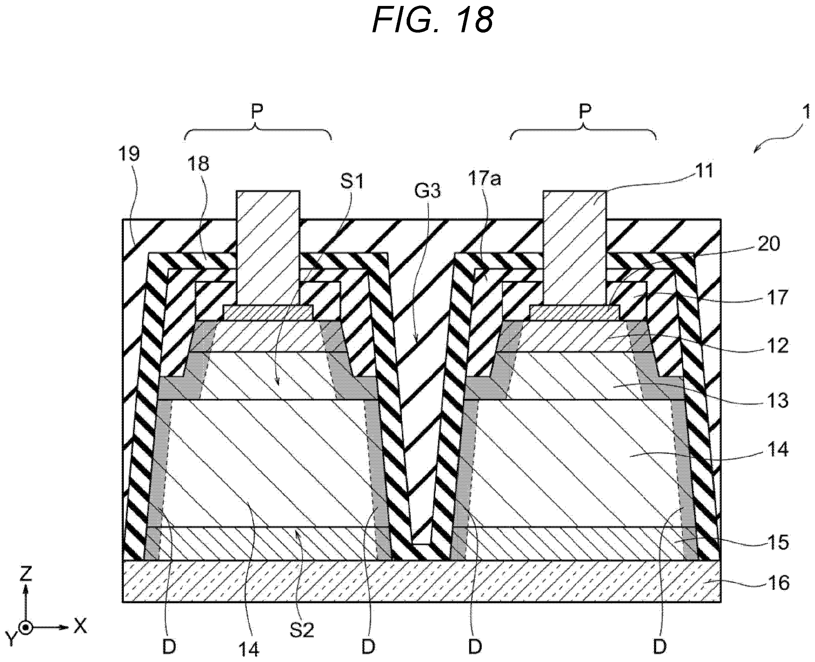

Fig. 18 illustrates a schematic cross-sectional configuration of the solid-state imaging element 1 according to a third modified example of the second embodiment described above. The third modified example of the second embodiment is different from the first modified example of the second embodiment in that the conductivity type is reversed.

The solid-state imaging element 1 in Fig. 14 described in the first modified example of the second embodiment has a p-type pixel, that is, an electronic readout structure. On the other hand, the solid-state imaging element 1 in Fig. 18 has a n-type pixel, that is, a hole readout structure. In addition, because the diffusion region D in Fig. 18 is the n-type, the dopant of the diffusion region D is, for example, silicon (Si), germanium (Ge), or the like.

As in the present modified example, holes may be read out as signal charges. Also in this case, the same effects as those of the first embodiment described above can be obtained.

### <<Application examples>>

The technology according to the present disclosure can be applied to various products. For example, the technology according to the present disclosure may also be realized as a device mounted on any type of mobile body such as an automobile, an electric automobile, a hybrid electric automobile, a motorcycle, a bicycle, a personal mobility, an airplane, a drone, a ship, a robot, a building machine, or an agricultural machine (tractor).

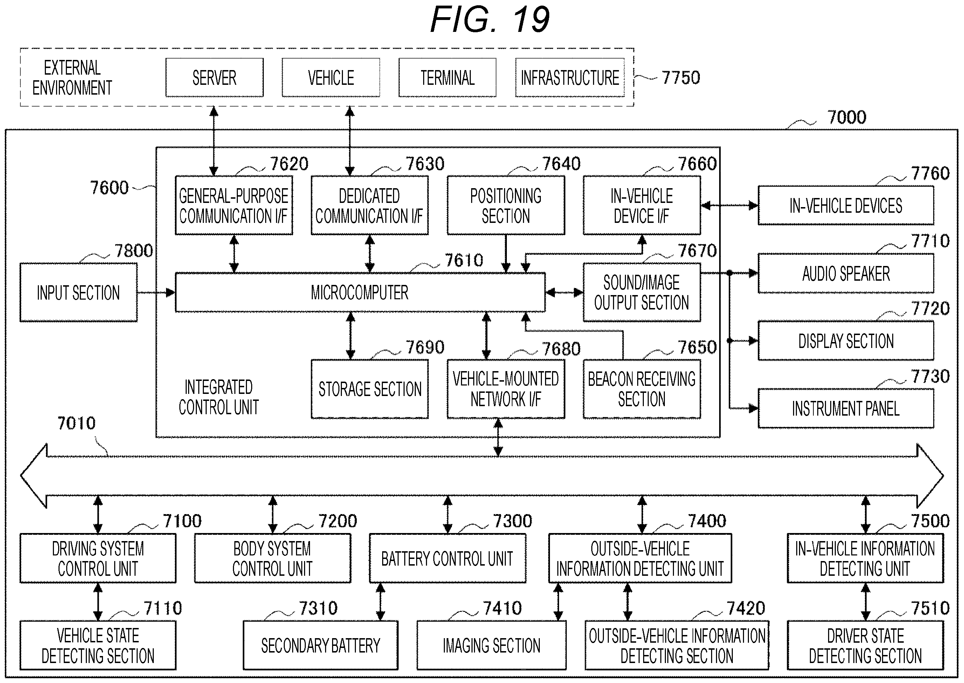

Fig. 19 is a block diagram illustrating an example of schematic configuration of a vehicle control system 7000 as an example of a mobile body control system to which the technology according to the present disclosure can be applied. The vehicle control system 7000 includes a plurality of electronic control units connected to each other via a communication network 7010. In the example illustrated in Fig. 19, the vehicle control system 7000 includes a driving system control unit 7100, a body system control unit 7200, a battery control unit 7300, an outside-vehicle information detecting unit 7400, an in-vehicle information detecting unit 7500, and an integrated control unit 7600. The communication network 7010 connecting the plurality of control units to each other may, for example, be a vehicle-mounted communication network compliant with an arbitrary standard such as controller area network (CAN), local interconnect network (LIN), local area network (LAN), FlexRay (registered trademark), or the like.

Each of the control units includes: a microcomputer that performs arithmetic processing according to various kinds of programs; a storage section that stores the programs executed by the microcomputer, parameters used for various kinds of operations, or the like; and a driving circuit that drives various kinds of control target devices. Each of the control units further includes: a network interface (I/F) for performing communication with other control units via the communication network 7010; and a communication I/F for performing communication with a device, a sensor, or the like within and without the vehicle by wire communication or radio communication. A functional configuration of the integrated control unit 7600 illustrated in Fig. 19 includes a microcomputer 7610, a general-purpose communication I/F 7620, a dedicated communication I/F 7630, a positioning section 7640, a beacon receiving section 7650, an in-vehicle device I/F 7660, a sound/image output section 7670, a vehicle-mounted network I/F 7680, and a storage section 7690. The other control units similarly include a microcomputer, a communication I/F, a storage section, and the like.

The driving system control unit 7100 controls the operation of devices related to the driving system of the vehicle in accordance with various kinds of programs. For example, the driving system control unit 7100 functions as a control device for a driving force generating device for generating the driving force of the vehicle, such as an internal combustion engine, a driving motor, or the like, a driving force transmitting mechanism for transmitting the driving force to wheels, a steering mechanism for adjusting the steering angle of the vehicle, a braking device for generating the braking force of the vehicle, and the like. The driving system control unit 7100 may have a function as a control device of an antilock brake system (ABS), electronic stability control (ESC), or the like.

The driving system control unit 7100 is connected with a vehicle state detecting section 7110. The vehicle state detecting section 7110, for example, includes at least one of a gyro sensor that detects the angular velocity of axial rotational movement of a vehicle body, an acceleration sensor that detects the acceleration of the vehicle, and sensors for detecting an amount of operation of an accelerator pedal, an amount of operation of a brake pedal, the steering angle of a steering wheel, an engine speed or the rotational speed of wheels, and the like. The driving system control unit 7100 performs arithmetic processing using a signal input from the vehicle state detecting section 7110, and controls the internal combustion engine, the driving motor, an electric power steering device, the brake device, and the like.

The body system control unit 7200 controls the operation of various kinds of devices provided to the vehicle body in accordance with various kinds of programs. For example, the body system control unit 7200 functions as a control device for a keyless entry system, a smart key system, a power window device, or various kinds of lamps such as a headlamp, a backup lamp, a brake lamp, a turn signal, a fog lamp, or the like. In this case, radio waves transmitted from a mobile device as an alternative to a key or signals of various kinds of switches can be input to the body system control unit 7200. The body system control unit 7200 receives these input radio waves or signals, and controls a door lock device, the power window device, the lamps, or the like of the vehicle.

The battery control unit 7300 controls a secondary battery 7310, which is a power supply source for the driving motor, in accordance with various kinds of programs. For example, the battery control unit 7300 is supplied with information about a battery temperature, a battery output voltage, an amount of charge remaining in the battery, or the like from a battery device including the secondary battery 7310. The battery control unit 7300 performs arithmetic processing using these signals, and performs control for regulating the temperature of the secondary battery 7310 or controls a cooling device provided to the battery device or the like.

The outside-vehicle information detecting unit 7400 detects information about the outside of the vehicle including the vehicle control system 7000. For example, the outside-vehicle information detecting unit 7400 is connected with at least one of an imaging section 7410 and an outside-vehicle information detecting section 7420. The imaging section 7410 includes at least one of a time-of-flight (ToF) camera, a stereo camera, a monocular camera, an infrared camera, and other cameras. The outside-vehicle information detecting section 7420, for example, includes at least one of an environmental sensor for detecting current atmospheric conditions or weather conditions and a peripheral information detecting sensor for detecting another vehicle, an obstacle, a pedestrian, or the like on the periphery of the vehicle including the vehicle control system 7000.

The environmental sensor, for example, may be at least one of a rain drop sensor detecting rain, a fog sensor detecting a fog, a sunshine sensor detecting a degree of sunshine, and a snow sensor detecting a snowfall. The peripheral information detecting sensor may be at least one of an ultrasonic sensor, a radar device, and a LIDAR device (Light detection and Ranging device, or Laser imaging detection and ranging device). Each of the imaging section 7410 and the outside-vehicle information detecting section 7420 may be provided as an independent sensor or device, or may be provided as a device in which a plurality of sensors or devices are integrated.

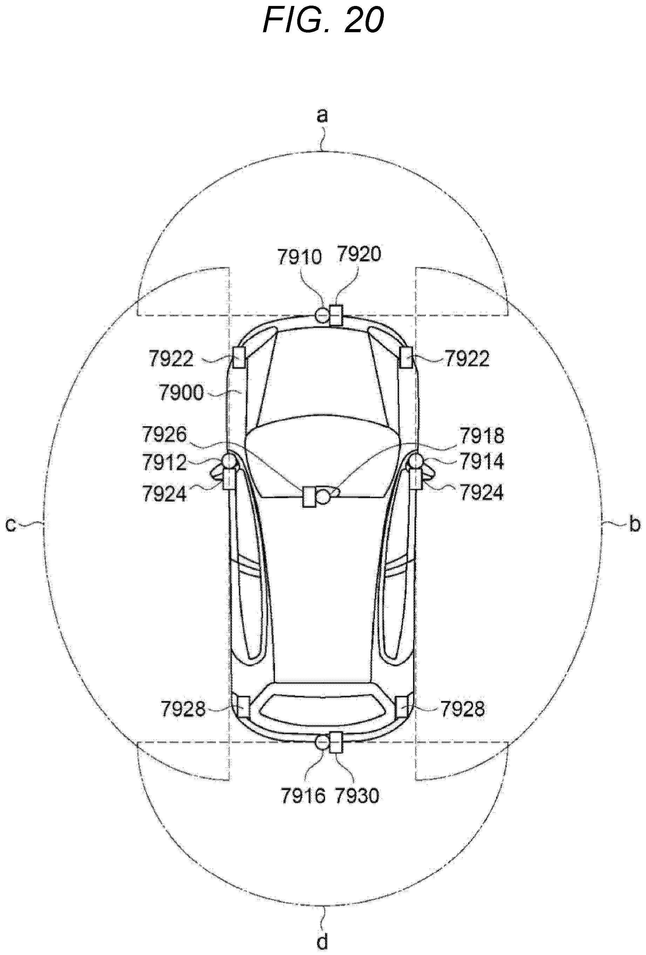

Here, Fig. 20 illustrates an example of installation positions of the imaging section 7410 and the outside-vehicle information detecting section 7420. Imaging sections 7910, 7912, 7914, 7916, and 7918 are, for example, disposed at at least one of positions on a front nose, sideview mirrors, a rear bumper, and a back door of the vehicle 7900 and a position on an upper portion of a windshield within the interior of the vehicle. The imaging section 7910 provided to the front nose and the imaging section 7918 provided to the upper portion of the windshield within the interior of the vehicle obtain mainly an image of the front of the vehicle 7900. The imaging sections 7912 and 7914 provided to the sideview mirrors obtain mainly an image of the sides of the vehicle 7900. The imaging section 7916 provided to the rear bumper or the back door obtains mainly an image of the rear of the vehicle 7900. The imaging section 7918 provided to the upper portion of the windshield within the interior of the vehicle is used mainly to detect a preceding vehicle, a pedestrian, an obstacle, a signal, a traffic sign, a lane, or the like.

Note that Fig. 20 illustrates an example of imaging ranges of the respective imaging sections 7910, 7912, 7914, and 7916. An imaging range a represents the imaging range of the imaging section 7910 provided to the front nose. Imaging ranges b and c respectively represent the imaging ranges of the imaging sections 7912 and 7914 provided to the sideview mirrors. An imaging range d represents the imaging range of the imaging section 7916 provided to the rear bumper or the back door. A bird's-eye image of the vehicle 7900 as viewed from above can be obtained by superimposing image data imaged by the imaging sections 7910, 7912, 7914, and 7916, for example.

Outside-vehicle information detecting sections 7920, 7922, 7924, 7926, 7928, and 7930 provided to the front, rear, sides, and corners of the vehicle 7900 and the upper portion of the windshield within the interior of the vehicle may be, for example, an ultrasonic sensor or a radar device. The outside-vehicle information detecting sections 7920, 7926, and 7930 provided to the front nose of the vehicle 7900, the rear bumper, the back door of the vehicle 7900, and the upper portion of the windshield within the interior of the vehicle may be a LIDAR device, for example. These outside-vehicle information detecting sections 7920 to 7930 are used mainly to detect a preceding vehicle, a pedestrian, an obstacle, or the like.

Returning to Fig. 19, the description will be continued. The outside-vehicle information detecting unit 7400 makes the imaging section 7410 image an image of the outside of the vehicle, and receives imaged image data. In addition, the outside-vehicle information detecting unit 7400 receives detection information from the outside-vehicle information detecting section 7420 connected to the outside-vehicle information detecting unit 7400. In a case where the outside-vehicle information detecting section 7420 is an ultrasonic sensor, a radar device, or a LIDAR device, the outside-vehicle information detecting unit 7400 transmits an ultrasonic wave, an electromagnetic wave, or the like, and receives information of a received reflected wave. On the basis of the received information, the outside-vehicle information detecting unit 7400 may perform processing of detecting an object such as a human, a vehicle, an obstacle, a sign, a character on a road surface, or the like, or processing of detecting a distance thereto. The outside-vehicle information detecting unit 7400 may perform environment recognition processing of recognizing a rainfall, a fog, road surface conditions, or the like on the basis of the received information. The outside-vehicle information detecting unit 7400 may calculate a distance to an object outside the vehicle on the basis of the received information.

In addition, on the basis of the received image data, the outside-vehicle information detecting unit 7400 may perform image recognition processing of recognizing a human, a vehicle, an obstacle, a sign, a character on a road surface, or the like, or processing of detecting a distance thereto. The outside-vehicle information detecting unit 7400 may subject the received image data to processing such as distortion correction, alignment, or the like, and combine the image data imaged by a plurality of different imaging sections 7410 to generate a bird's-eye image or a panoramic image. The outside-vehicle information detecting unit 7400 may perform viewpoint conversion processing using the image data imaged by the imaging section 7410 including the different imaging parts.

The in-vehicle information detecting unit 7500 detects information about the inside of the vehicle. The in-vehicle information detecting unit 7500 is, for example, connected with a driver state detecting section 7510 that detects the state of a driver. The driver state detecting section 7510 may include a camera that images the driver, a biosensor that detects biological information of the driver, a microphone that collects sound within the interior of the vehicle, or the like. The biosensor is, for example, disposed in a seat surface, the steering wheel, or the like, and detects biological information of an occupant sitting in a seat or the driver holding the steering wheel. On the basis of detection information input from the driver state detecting section 7510, the in-vehicle information detecting unit 7500 may calculate a degree of fatigue of the driver or a degree of concentration of the driver, or may determine whether the driver is dozing. The in-vehicle information detecting unit 7500 may subject an audio signal obtained by the collection of the sound to processing such as noise canceling processing or the like.

The integrated control unit 7600 controls general operation within the vehicle control system 7000 in accordance with various kinds of programs. The integrated control unit 7600 is connected with an input section 7800. The input section 7800 is implemented by a device capable of input operation by an occupant, such, for example, as a touch panel, a button, a microphone, a switch, a lever, or the like. The integrated control unit 7600 may be supplied with data obtained by voice recognition of voice input through the microphone. The input section 7800 may, for example, be a remote control device using infrared rays or other radio waves, or an external connecting device such as a mobile telephone, a personal digital assistant (PDA), or the like that supports operation of the vehicle control system 7000. The input section 7800 may be, for example, a camera. In that case, an occupant can input information by gesture. Alternatively, data may be input which is obtained by detecting the movement of a wearable device that an occupant wears. Further, the input section 7800 may, for example, include an input control circuit or the like that generates an input signal on the basis of information input by an occupant or the like using the above-described input section 7800, and which outputs the generated input signal to the integrated control unit 7600. An occupant or the like inputs various kinds of data or gives an instruction for processing operation to the vehicle control system 7000 by operating the input section 7800.

The storage section 7690 may include a read only memory (ROM) that stores various kinds of programs executed by the microcomputer and a random access memory (RAM) that stores various kinds of parameters, operation results, sensor values, or the like. In addition, the storage section 7690 may be implemented by a magnetic storage device such as a hard disc drive (HDD) or the like, a semiconductor storage device, an optical storage device, a magneto-optical storage device, or the like.

The general-purpose communication I/F 7620 is a communication I/F used widely, which communication I/F mediates communication with various apparatuses present in an external environment 7750. The general-purpose communication I/F 7620 may implement a cellular communication protocol such as global system for mobile communications (GSM (registered trademark)), worldwide interoperability for microwave access (WiMAX (registered trademark)), long term evolution (LTE (registered trademark)), LTE-advanced (LTE-A), or the like, or another wireless communication protocol such as wireless LAN (referred to also as wireless fidelity (Wi-Fi (registered trademark)), Bluetooth (registered trademark), or the like. The general-purpose communication I/F 7620 may, for example, connect to an apparatus (for example, an application server or a control server) present on an external network (for example, the Internet, a cloud network, or a company-specific network) via a base station or an access point. In addition, the general-purpose communication I/F 7620 may connect to a terminal present in the vicinity of the vehicle (which terminal is, for example, a terminal of the driver, a pedestrian, or a store, or a machine type communication (MTC) terminal) using a peer to peer (P2P) technology, for example.

The dedicated communication I/F 7630 is a communication I/F that supports a communication protocol developed for use in vehicles. The dedicated communication I/F 7630 may implement a standard protocol such, for example, as wireless access in vehicle environment (WAVE), which is a combination of institute of electrical and electronic engineers (IEEE) 802.11p as a lower layer and IEEE 1609 as a higher layer, dedicated short range communications (DSRC), or a cellular communication protocol. The dedicated communication I/F 7630 typically carries out V2X communication as a concept including one or more of communication between a vehicle and a vehicle (Vehicle to Vehicle), communication between a road and a vehicle (Vehicle to Infrastructure), communication between a vehicle and a home (Vehicle to Home), and communication between a pedestrian and a vehicle (Vehicle to Pedestrian).

The positioning section 7640, for example, performs positioning by receiving a global navigation satellite system (GNSS) signal from a GNSS satellite (for example, a GPS signal from a global positioning system (GPS) satellite), and generates positional information including the latitude, longitude, and altitude of the vehicle. Incidentally, the positioning section 7640 may identify a current position by exchanging signals with a wireless access point, or may obtain the positional information from a terminal such as a mobile telephone, a personal handyphone system (PHS), or a smart phone that has a positioning function.

The beacon receiving section 7650, for example, receives a radio wave or an electromagnetic wave transmitted from a radio station installed on a road or the like, and thereby obtains information about the current position, congestion, a closed road, a necessary time, or the like. Incidentally, the function of the beacon receiving section 7650 may be included in the dedicated communication I/F 7630 described above.

The in-vehicle device I/F 7660 is a communication interface that mediates connection between the microcomputer 7610 and various in-vehicle devices 7760 present within the vehicle. The in-vehicle device I/F 7660 may establish wireless connection using a wireless communication protocol such as wireless LAN, Bluetooth (registered trademark), near field communication (NFC), or wireless universal serial bus (WUSB). In addition, the in-vehicle device I/F 7660 may establish wired connection by universal serial bus (USB), high-definition multimedia interface (HDMI (registered trademark)), mobile high-definition link (MHL), or the like via a connection terminal (and a cable if necessary) not depicted in the figures. The in-vehicle devices 7760 may, for example, include at least one of a mobile device and a wearable device possessed by an occupant and an information device carried into or attached to the vehicle. The in-vehicle devices 7760 may also include a navigation device that searches for a path to an arbitrary destination. The in-vehicle device I/F 7660 exchanges control signals or data signals with these in-vehicle devices 7760.

The vehicle-mounted network I/F 7680 is an interface that mediates communication between the microcomputer 7610 and the communication network 7010. The vehicle-mounted network I/F 7680 transmits and receives signals or the like in conformity with a predetermined protocol supported by the communication network 7010.

The microcomputer 7610 of the integrated control unit 7600 controls the vehicle control system 7000 in accordance with various kinds of programs on the basis of information obtained via at least one of the general-purpose communication I/F 7620, the dedicated communication I/F 7630, the positioning section 7640, the beacon receiving section 7650, the in-vehicle device I/F 7660, and the vehicle-mounted network I/F 7680. For example, the microcomputer 7610 may calculate a control target value for the driving force generating device, the steering mechanism, or the braking device on the basis of the obtained information about the inside and outside of the vehicle, and output a control command to the driving system control unit 7100. For example, the microcomputer 7610 may perform cooperative control intended to implement functions of an advanced driver assistance system (ADAS) which functions include collision avoidance or shock mitigation for the vehicle, following driving based on a following distance, vehicle speed maintaining driving, a warning of collision of the vehicle, a warning of deviation of the vehicle from a lane, or the like. In addition, the microcomputer 7610 may perform cooperative control intended for automated driving, which makes the vehicle to travel automatedly without depending on the operation of the driver, or the like, by controlling the driving force generating device, the steering mechanism, the braking device, or the like on the basis of the obtained information about the surroundings of the vehicle.

The microcomputer 7610 may generate three-dimensional distance information between the vehicle and an object such as a surrounding structure, a person, or the like, and generate local map information including information about the surroundings of the current position of the vehicle, on the basis of information obtained via at least one of the general-purpose communication I/F 7620, the dedicated communication I/F 7630, the positioning section 7640, the beacon receiving section 7650, the in-vehicle device I/F 7660, and the vehicle-mounted network I/F 7680. In addition, the microcomputer 7610 may predict danger such as collision of the vehicle, approaching of a pedestrian or the like, an entry to a closed road, or the like on the basis of the obtained information, and generate a warning signal. The warning signal may, for example, be a signal for producing a warning sound or lighting a warning lamp.

The sound/image output section 7670 transmits an output signal of at least one of a sound and an image to an output device capable of visually or auditorily notifying information to an occupant of the vehicle or the outside of the vehicle. In the example in Fig. 19, an audio speaker 7710, a display section 7720, and an instrument panel 7730 are illustrated as the output device. The display section 7720 may, for example, include at least one of an on-board display and a head-up display. The display section 7720 may have an augmented reality (AR) display function. The output device may be other than these devices, and may be another device such as headphones, a wearable device such as an eyeglass type display worn by an occupant or the like, a projector, a lamp, or the like. In a case where the output device is a display device, the display device visually displays results obtained by various kinds of processing performed by the microcomputer 7610 or information received from another control unit in various forms such as text, an image, a table, a graph, or the like. In addition, in a case where the output device is an audio output device, the audio output device converts an audio signal constituted of reproduced audio data or sound data or the like into an analog signal, and auditorily outputs the analog signal.

Note that at least two control units connected to each other via the communication network 7010 in the example illustrated in Fig. 19 may be integrated into one control unit. Alternatively, each individual control unit may include a plurality of control units. Further, the vehicle control system 7000 may include another control unit not depicted in the figures. In addition, part or the whole of the functions performed by one of the control units in the above description may be assigned to another control unit. That is, predetermined arithmetic processing may be performed by any of the control units as long as information is transmitted and received via the communication network 7010. Similarly, a sensor or a device connected to one of the control units may be connected to another control unit, and a plurality of control units may mutually transmit and receive detection information via the communication network 7010.

Note that the present technology can have the following configurations.
(1) A solid-state imaging element including:
   a photoelectric conversion layer containing a compound semiconductor material;
   two semiconductor layers laminated and disposed on an opposite side of a light incident surface of the photoelectric conversion layer, the two semiconductor layers containing impurities of different conductivity types from each other; and
   a diffusion layer disposed in sidewalls of the photoelectric conversion layer and the two semiconductor layers, the diffusion layer containing impurities of an impurity concentration higher than an impurity concentration of the two semiconductor layers,
   in which the two semiconductor layers have a width in a plane direction excluding the diffusion layer in the sidewalls, the width being narrower than a width of the photoelectric conversion layer in a plane direction excluding the diffusion layer in the sidewall.
(2) The solid-state imaging element according to (1), in which the two semiconductor layers include:
   a first semiconductor layer containing impurities of a first conductivity type; and
   a second semiconductor layer disposed between the first semiconductor layer and the photoelectric conversion layer and containing impurities of a second conductivity type, and
   the diffusion layer is disposed in the sidewalls of the first semiconductor layer and the second semiconductor layer, and contains impurities of the second conductivity type having an impurity concentration higher than an impurity concentration of the second semiconductor layer.
(3) The solid-state imaging element according to (1) or (2), in which the diffusion layer in the sidewalls of the two semiconductor layers is thicker than the diffusion layer in the sidewall of the photoelectric conversion layer.
(4) The solid-state imaging element according to (3), in which the width in the plane direction of the two semiconductor layers including the diffusion layer in the sidewalls is substantially the same as the width in the plane direction of the photoelectric conversion layer including the diffusion layer in the sidewall, or the width in the plane direction is continuously narrowed from the side of the light incident surface of the photoelectric conversion layer including the diffusion layer in the sidewall toward the two semiconductor layers.
(5) The solid-state imaging element according to (3) or (4), further including a third semiconductor layer disposed on the side of the light incident surface of the photoelectric conversion layer and having a same conductivity type as the photoelectric conversion layer, in which
   the diffusion layer disposed in a sidewall of the third semiconductor layer is thicker than the diffusion layer in the sidewall of the photoelectric conversion layer and thinner than the diffusion layer in the sidewalls of the two semiconductor layers.
(6) The solid-state imaging element according to any one of (3) to (5), in which
   the two semiconductor layers include:
   a first semiconductor layer containing impurities of a first conductivity type; and
   a second semiconductor layer disposed between the first semiconductor layer and the photoelectric conversion layer and containing impurities of a second conductivity type,
   the solid-state imaging element further includes a first insulating film disposed on the first semiconductor layer and disposed inside the first semiconductor layer in plan view from an opposite side of the light incident surface, and
   the diffusion layer in the sidewall of the first semiconductor layer is thicker than the diffusion layer in the sidewall of the second semiconductor layer.
(7) The solid-state imaging element according to (1) or (2), in which the two semiconductor layers including the diffusion layer in the sidewalls have a width in the plane direction gradually narrowed from the photoelectric conversion layer including the diffusion layer in the sidewall.
(8) The solid-state imaging element according to (7), in which the diffusion layer in the sidewalls of the two semiconductor layers has a thickness substantially the same as a thickness of the diffusion layer in the sidewall of the photoelectric conversion layer.
(9) The solid-state imaging element according to (7) or (8), in which the diffusion layer in the sidewalls of the two semiconductor layers is thicker than the diffusion layer in the sidewall of the photoelectric conversion layer.
(10) The solid-state imaging element according to (9), further including:
   a first insulating film disposed so as to cover the diffusion layer in the sidewalls of the two semiconductor layers; and
   a second insulating film disposed so as to cover the diffusion layer in the sidewall of the photoelectric conversion layer and being different from the first insulating film.
(11) The solid-state imaging element according to any one of (1) to (10), further including
   an electrode that is disposed so as to sandwich the two semiconductor layers between the electrode and the photoelectric conversion layer and reads out charges photoelectrically converted by the photoelectric conversion layer, in which
   the diffusion layer in the sidewalls of the two semiconductor layers is disposed so as to be close to the electrode while being spaced apart from the electrode.
(12) The solid-state imaging element according to any one of (1) to (10), further including:
   an electrode that is disposed so as to sandwich the two semiconductor layers between the electrode and the photoelectric conversion layer and reads out charges photoelectrically converted by the photoelectric conversion layer; and
   a fourth semiconductor layer that is disposed between the two semiconductor layers and the electrode and has a conductivity type different from a conductivity type of the photoelectric conversion layer, in which
   the diffusion layer of the sidewalls of the two semiconductor layers is disposed so as to be close to the fourth semiconductor layer while being spaced apart from the fourth semiconductor layer.
(13) The solid-state imaging element according to any one of (1) to (12), in which the two semiconductor layers have band gap energy larger than band gap energy of the photoelectric conversion layer.
(14) A manufacturing method of a solid-state imaging element, the manufacturing method including:
   forming a laminate of a photoelectric conversion layer containing a compound semiconductor material and two semiconductor layers that are laminated, the two semiconductor layers containing impurities of conductivity types different from each other;
   forming a diffusion layer in the two semiconductor layers, the diffusion layer containing impurities of an impurity concentration higher than an impurity concentration of the two semiconductor layers;
   forming a first groove that exposes the diffusion layer in sidewalls of the two semiconductor layers and a sidewall of the photoelectric conversion layer; and
   forming the diffusion layer in the sidewall of the photoelectric conversion layer, and making the diffusion layer in the sidewalls of the two semiconductor layers thicker than the diffusion layer in the sidewall of the photoelectric conversion layer.
(15) The manufacturing method of the solid-state imaging element according to (14), further including:
   after forming the laminate,
   forming a first insulating film on the laminate, the first insulating film being disposed for each pixel;
   forming the diffusion layer in the two semiconductor layers using the first insulating film as a mask;
   after forming the first groove,
   removing an outer peripheral part of the first insulating film such that the first insulating film is disposed inside the two semiconductor layers in plan view from an opposite side of a light incident surface of the photoelectric conversion layer; and
   forming the diffusion layer in the sidewall of the photoelectric conversion layer using the first insulating film as a mask, and making the diffusion layer in the sidewalls of the two semiconductor layers thicker than the diffusion layer in the sidewall of the photoelectric conversion layer.
(16) A manufacturing method of a solid-state imaging element, the manufacturing method including:
   forming a laminate of a photoelectric conversion layer containing a compound semiconductor material and two semiconductor layers that are laminated, the two semiconductor layers containing impurities of conductivity types different from each other;
   forming a first groove that exposes sidewalls of the two semiconductor layers and a sidewall of the photoelectric conversion layer;
   removing a part of the two semiconductor layers from a side of the sidewalls;
   forming a diffusion layer in the sidewalls of the photoelectric conversion layer and the two semiconductor layers, the diffusion layer containing impurities of an impurity concentration higher than an impurity concentration of the two semiconductor layers.
(17) A manufacturing method of a solid-state imaging element, the manufacturing method including:
   forming a laminate of a photoelectric conversion layer containing a compound semiconductor material and two semiconductor layers that are laminated, the two semiconductor layers containing impurities of conductivity types different from each other;
   forming a second groove that exposes sidewalls of the two semiconductor layers;
   forming a diffusion layer in the sidewalls of the two semiconductor layers, the diffusion layer containing impurities of an impurity concentration higher than an impurity concentration of the two semiconductor layers;
   forming a third groove that exposes a sidewall of the photoelectric conversion layer, the third groove being narrower than the second groove; and
   forming the diffusion layer in the sidewall of the photoelectric conversion layer, and making the diffusion layer in the sidewalls of the two semiconductor layers thicker than the diffusion layer in the sidewall of the photoelectric conversion layer.
(18) The manufacturing method of the solid-state imaging element according to (17), further including:
   after forming the diffusion layer in the sidewalls of the two semiconductor layers,
   forming a first insulating film covering the diffusion layer in the sidewalls of the two semiconductor layers; and
   after forming the diffusion layer in the sidewall of the photoelectric conversion layer and thickening the diffusion layer in the sidewalls of the two semiconductor layers,
   forming a second insulating film different from the first insulating film, the second insulating film covering the diffusion layer in the sidewall of the photoelectric conversion layer.

Aspects of the present disclosure are not limited to the above-described individual embodiments, but include various modifications that can be conceived by those skilled in the art, and the effects of the present disclosure are not limited to the above-described contents. That is, various additions, modifications, and partial deletions are possible without departing from the conceptual idea and spirit of the present disclosure derived from the matters defined in the claims and equivalents thereof.

### REFERENCE SIGNS LIST

- 1: Solid-state imaging element
- 11: First electrode
- 12: First semiconductor layer
- 13: Second semiconductor layer
- 14: Light absorbing layer
- 15: Contact layer
- 16: Second electrode
- 17: Insulating film
- 17a: Insulating film
- 18: Coating film
- 19: Protective film
- 20: Contact layer
- D: Diffusion region
- G1: First groove
- G2: Second groove
- G3: Third groove
- P: Pixel
- 51: First surface
- S2: Second surface

## Claims

1. A solid-state imaging element comprising:
a photoelectric conversion layer containing a compound semiconductor material;
two semiconductor layers laminated and disposed on an opposite side of a light incident surface of the photoelectric conversion layer, the two semiconductor layers containing impurities of different conductivity types from each other; and
a diffusion layer disposed in sidewalls of the photoelectric conversion layer and the two semiconductor layers, the diffusion layer containing impurities of an impurity concentration higher than an impurity concentration of the two semiconductor layers,
wherein the two semiconductor layers have a width in a plane direction excluding the diffusion layer in the sidewalls, the width being narrower than a width of the photoelectric conversion layer in a plane direction excluding the diffusion layer in the sidewall.

2. The solid-state imaging element according to claim 1, wherein the two semiconductor layers include:
a first semiconductor layer containing impurities of a first conductivity type; and
a second semiconductor layer disposed between the first semiconductor layer and the photoelectric conversion layer and containing impurities of a second conductivity type, and
the diffusion layer is disposed in the sidewalls of the first semiconductor layer and the second semiconductor layer, and contains impurities of the second conductivity type having an impurity concentration higher than an impurity concentration of the second semiconductor layer.

3. The solid-state imaging element according to claim 1, wherein the diffusion layer in the sidewalls of the two semiconductor layers is thicker than the diffusion layer in the sidewall of the photoelectric conversion layer.

4. The solid-state imaging element according to claim 3, wherein the width in the plane direction of the two semiconductor layers including the diffusion layer in the sidewalls is substantially a same as the width in the plane direction of the photoelectric conversion layer including the diffusion layer in the sidewall, or the width in the plane direction is continuously narrowed from the side of the light incident surface of the photoelectric conversion layer including the diffusion layer in the sidewall toward the two semiconductor layers.

5. The solid-state imaging element according to claim 3, further comprising a third semiconductor layer disposed on the side of the light incident surface of the photoelectric conversion layer and having a same conductivity type as the photoelectric conversion layer, wherein
the diffusion layer disposed in a sidewall of the third semiconductor layer is thicker than the diffusion layer in the sidewall of the photoelectric conversion layer and thinner than the diffusion layer in the sidewalls of the two semiconductor layers.

6. The solid-state imaging element according to claim 3, wherein
the two semiconductor layers include:
a first semiconductor layer containing impurities of a first conductivity type; and
a second semiconductor layer disposed between the first semiconductor layer and the photoelectric conversion layer and containing impurities of a second conductivity type,
the solid-state imaging element further comprises a first insulating film disposed on the first semiconductor layer and disposed inside the first semiconductor layer in plan view from an opposite side of the light incident surface, and
the diffusion layer in the sidewall of the first semiconductor layer is thicker than the diffusion layer in the sidewall of the second semiconductor layer.

7. The solid-state imaging element according to claim 1, wherein the two semiconductor layers including the diffusion layer in the sidewalls have a width in the plane direction gradually narrowed from the photoelectric conversion layer including the diffusion layer in the sidewall.

8. The solid-state imaging element according to claim 7, wherein the diffusion layer in the sidewalls of the two semiconductor layers has a thickness substantially a same as a thickness of the diffusion layer in the sidewall of the photoelectric conversion layer.

9. The solid-state imaging element according to claim 7, wherein the diffusion layer in the sidewalls of the two semiconductor layers is thicker than the diffusion layer in the sidewall of the photoelectric conversion layer.

10. The solid-state imaging element according to claim 9, further comprising:
a first insulating film disposed so as to cover the diffusion layer in the sidewalls of the two semiconductor layers; and
a second insulating film disposed so as to cover the diffusion layer in the sidewall of the photoelectric conversion layer and being different from the first insulating film.

11. The solid-state imaging element according to claim 1, further comprising
an electrode that is disposed so as to sandwich the two semiconductor layers between the electrode and the photoelectric conversion layer and reads out charges photoelectrically converted by the photoelectric conversion layer, wherein
the diffusion layer in the sidewalls of the two semiconductor layers is disposed so as to be close to the electrode while being spaced apart from the electrode.

12. The solid-state imaging element according to claim 1, further comprising:
an electrode that is disposed so as to sandwich the two semiconductor layers between the electrode and the photoelectric conversion layer and reads out charges photoelectrically converted by the photoelectric conversion layer; and
a fourth semiconductor layer that is disposed between the two semiconductor layers and the electrode and has a conductivity type different from a conductivity type of the photoelectric conversion layer, wherein
the diffusion layer of the sidewalls of the two semiconductor layers is disposed so as to be close to the fourth semiconductor layer while being spaced apart from the fourth semiconductor layer.

13. The solid-state imaging element according to claim 1, wherein the two semiconductor layers have band gap energy larger than band gap energy of the photoelectric conversion layer.

14. A manufacturing method of a solid-state imaging element, the manufacturing method comprising:
forming a laminate of a photoelectric conversion layer containing a compound semiconductor material and two semiconductor layers that are laminated, the two semiconductor layers containing impurities of conductivity types different from each other;
forming a diffusion layer in the two semiconductor layers, the diffusion layer containing impurities of an impurity concentration higher than an impurity concentration of the two semiconductor layers;
forming a first groove that exposes the diffusion layer in sidewalls of the two semiconductor layers and a sidewall of the photoelectric conversion layer; and
forming the diffusion layer in the sidewall of the photoelectric conversion layer, and making the diffusion layer in the sidewalls of the two semiconductor layers thicker than the diffusion layer in the sidewall of the photoelectric conversion layer.

15. The manufacturing method of the solid-state imaging element according to claim 14, further comprising:
after forming the laminate,
forming a first insulating film on the laminate, the first insulating film being disposed for each pixel;
forming the diffusion layer in the two semiconductor layers using the first insulating film as a mask;
after forming the first groove,
removing an outer peripheral part of the first insulating film such that the first insulating film is disposed inside the two semiconductor layers in plan view from an opposite side of a light incident surface of the photoelectric conversion layer; and
forming the diffusion layer in the sidewall of the photoelectric conversion layer using the first insulating film as a mask, and making the diffusion layer in the sidewalls of the two semiconductor layers thicker than the diffusion layer in the sidewall of the photoelectric conversion layer.

16. A manufacturing method of a solid-state imaging element, the manufacturing method comprising:
forming a laminate of a photoelectric conversion layer containing a compound semiconductor material and two semiconductor layers that are laminated, the two semiconductor layers containing impurities of conductivity types different from each other;
forming a first groove that exposes sidewalls of the two semiconductor layers and a sidewall of the photoelectric conversion layer;
removing a part of the two semiconductor layers from a side of the sidewalls;
forming a diffusion layer in the sidewalls of the photoelectric conversion layer and the two semiconductor layers, the diffusion layer containing impurities of an impurity concentration higher than an impurity concentration of the two semiconductor layers.

17. A manufacturing method of a solid-state imaging element, the manufacturing method comprising:
forming a laminate of a photoelectric conversion layer containing a compound semiconductor material and two semiconductor layers that are laminated, the two semiconductor layers containing impurities of conductivity types different from each other;
forming a second groove that exposes sidewalls of the two semiconductor layers;
forming a diffusion layer in the sidewalls of the two semiconductor layers, the diffusion layer containing impurities of an impurity concentration higher than an impurity concentration of the two semiconductor layers;
forming a third groove that exposes a sidewall of the photoelectric conversion layer, the third groove being narrower than the second groove; and
forming the diffusion layer in the sidewall of the photoelectric conversion layer, and making the diffusion layer in the sidewalls of the two semiconductor layers thicker than the diffusion layer in the sidewall of the photoelectric conversion layer.

18. The manufacturing method of the solid-state imaging element according to claim 17, further comprising:
after forming the diffusion layer in the sidewalls of the two semiconductor layers,
forming a first insulating film covering the diffusion layer in the sidewalls of the two semiconductor layers; and
after forming the diffusion layer in the sidewall of the photoelectric conversion layer and thickening the diffusion layer in the sidewalls of the two semiconductor layers,
forming a second insulating film different from the first insulating film, the second insulating film covering the diffusion layer in the sidewall of the photoelectric conversion layer.
